# EUROPEAN PATENT APPLICATION

(11) **EP 1 770 610 A2**
(43) Date of publication of application: **04.04.2007**
(21) Application number: 06019364.6
(22) Date of filing: 15.09.2006
(51) Int. Cl.: G06K 19/077

(54) **Semiconductor device**

(30) Priority: 29.09.2005 JP 2005285018
(71) Applicant: SEMICONDUCTOR ENERGY LABORATORY CO., LTD., Atsugi-shi, Kanagawa-ken 243-0036 (JP)
(72) Inventor: Kusumoto, Naoto Semiconductor Energy Lab. Co. Ltd., Kanagawa-ken, 243-0036 (JP); Takahashi, Hidekazu, Atsugi-shi Kanagawa-ken, 243-0036 (JP); Kobayashi, Yuka, Atsugi-shi Kanagawa-ken, 243-0036 (JP)
(74) Representative: Grünecker, Kinkeldey, Stockmair & Schwanhäusser Anwaltssozietät

(57) **Abstract**

The invention includes a layer having an integrated circuit, a first terminal which is formed over the layer having the integrated circuit and is electrically connected to the layer having the integrated circuit, a conductive layer which functions as an antenna, which is formed over the first terminal and is electrically connected to the first terminal, and a second terminal which is formed over the layer having the integrated circuit and is not electrically connected to the layer having the integrated circuit, the conductive layer which functions as the antenna, and the first terminal.

## Description

### BACKGROUND OF THE INVENTION

### 1. Field of the Invention

The present invention relates to a semiconductor device having a memory, a microprocessor (central processing unit, MPU), or the like and mounted with a thin film integrated circuit, which is thin and flexible like paper. In addition, the present invention relates to a non-contact type semiconductor device having the thin film integrated circuit and an antenna, which is used mainly for a card, a tag, a label, or the like for identifying human beings, animals and plants, commercial products, banknotes, or the like.

### 2. Description of the Related Art

In recent years, a semiconductor device capable of transmitting and receiving data has been actively developed, and such a semiconductor device is called an IC chip, an RF tag, a wireless tag, an electronic tag, a wireless processor, a wireless memory, or the like. Although the semiconductor devices which have been put into the practical use are mainly use single-crystalline silicon substrates, a thin film transistor circuit formed over a glass substrate or an ultrathin semiconductor device formed by transposing the circuit onto an organic resin film or the like has also been gradually commercialized.

Such a semiconductor device tends to be used in the product form of a sheet, a card, or the like in view of its variable application. Therefore, slimness and/or flexibility have/has been required, thus a method of thinning a semiconductor element in which a back surface of a base material of a silicon substrate or a glass substrate is grinded and polished and/or a structure in which an element is minimized so as not to cause bending fracture have/has been employed. In the case of transposing onto an organic resin film or the like, the flexibility can be controlled by selecting a material and thickness of the substrate which is transposed.

A semiconductor device in which an antenna is externally attached to a semiconductor element can manufacture a thin product such as a card or a tag by joining a terminal electrically connected to the thinned element and the external antenna with an ACP (Anisotropic Conductive Paste), an ACF (Anisotropic Conductive Film), an NCP (Non Conductive Paste), an NCF (Non Conductive Film), or the like, and sealing with a film or a resin. A semiconductor device with a built-in antenna in which the antenna is directly formed on an element can manufacture a similar product to that of the semiconductor device to which an antenna is externally attached, by directly sealing the antenna and the semiconductor element with a film or a resin. The antenna used here is manufactured using a conductive resin by screen printing or the like over a resin film so as to have flexibility.

In general, the semiconductor element and the antenna are electrically connected to each other using a terminal in minimum number regardless of whether the antenna is externally attached or built in, and have a structure of performing communication of power and signals. For example, in the case where a frequency band of 13.56 MHz is used, a loop antenna is used, and connecting terminals of which ends are the innermost circumference and the outermost circumference of the loop antenna are joined to terminals which serve for power supply system and signal input/output of the semiconductor element. Further, in the case where an UHF band that is a higher frequency band is used, pole-shaped antennas are disposed on right and left of the semiconductor element, and respective inner ends of the pole-shaped antennas are joined to terminals which serve for power supply system and signal input/output of the semiconductor element (e.g., Reference 1: Japanese-Patent Laid-Open No. 2005-202947)

However, a flexible product manufactured by joining the element and the antenna to each other has such a problem that it is weak against dynamic stress, e.g., bending or twisting, and is easy to destroy. This has been caused by destruction of an element substrate or by destruction of a joining portion with a part of a joining point used as a fulcrum, when bending stress is applied.

Conventionally, as a method of preventing the problem, it has been required to downsize an element itself so as not to bend the element. Therefore, a semiconductor device with a built-in antenna has such a problem that the size of the antenna is restricted, and thus communication distance thereof becomes short. In addition, there is such a problem that since the element area is restricted, the size and/or kind of memory capacity or the like is limited.

Furthermore, in the case where the element area is small, since a wide area for forming a terminal cannot be obtained, a device in which a terminal is provided over the element with an insulating layer interposed therebetween, or the like is required in addition to the above-described limitation. Accordingly, the number of manufacturing steps is increased, which causes reduction in the yield or increase in the cost.

In addition, in the case where the number of terminals is small, a load in pressure-bonding between an antenna material and the terminal is concentrated at the terminal portion, which destroys the element itself, or the load applied to each terminal is varied, thereby causing decrease in the yield.

### SUMMARY OF THE INVENTION

The present invention provides a semiconductor device of which mass production is possible and the structure is different from that of a conventional small-size element. In addition, it is an object of the invention to provide a structure of a semiconductor device of which the strength can be improved, destruction of an element in manufacturing can be suppressed, and the reliability and yield are high, and a manufacturing method of the semiconductor device.

The semiconductor device of the invention includes a transistor formed over a hard-plane substrate such as a glass substrate, and an element provided with flexibility by grinding and polishing a back surface of the hard-plane substrate or a element manufactured by transposing an element region including the transistor onto a resin substrate or the like that has flexibility. More specifically, the invention has such a structure that an element thinned by grinding and polishing a back surface of a hard-plane substrate or an element manufactured by transposing an element region onto a resin substrate or the like that has flexibility is joined to an antenna, and a plurality of terminals are provided on wirings, and on the antenna side, thereby a plurality of electrical-joining points are provided at different positions within an element surface. Note that in the invention, not all of the plurality of terminals are independent in electrical meaning or signal meaning, but the plurality of terminals are connected to any one of the wirings. By forming the plurality of terminals in number larger than the number of terminals minimum required, a region which is to be a fulcrum against bending is dispersed so that stress on one terminal can be dispersed.

In addition, as one structure of the semiconductor device of the invention, the number of joining points between a conductive layer which functions as an antenna and a terminal or a wiring is three or more, thereby a plane surface is formed two-dimensionally in accordance with the positional relationship of the joining points so that when bending stress is applied in parallel with a pair of terminals, the same stress is not applied to the other terminal(s). Therefore, even if destruction of a joining terminal occurs by stress, reliability of an element is not damaged as long as there is no problem in the other terminal joining(s) on the same wiring, thereby realizing redundant design. Further, in addition to the above-described structure, a terminal that does not affect electrically (hereinafter also referred to as a pseudo terminal) may be provided in plural number. This pseudo terminal which does not contribute to the redundancy is efficient in the case where wirings are provided so as to be concentrated within the element surface, and can be provided at an arbitrarily position within the element. Note that in the invention, the pseudo terminal can be provided so as to be symmetrical with respect to a terminal electrically connected to the antenna and the transistor. Specific structures of the semiconductor device of the invention are described below.

According to the invention, an insulating layer formed over an integrated circuit, a first terminal and a second terminal formed on a surface of the insulating layer, and a conductive layer which is formed over the first terminal and functions as an antenna electrically connected to the first terminal are included, in which the second terminal is electrically isolated from the conductive layer.

According to the invention, an insulating layer formed over an integrated circuit, a first terminal formed on a surface of the insulating layer, a conductive layer which is formed over the first terminal and functions as an antenna electrically connected to the first terminal, a substrate provided over the conductive layer which functions as the antenna, and a second terminal which is formed of the same layer on the same surface as the first terminal and is electrically isolated from the conductive layer are included, in which the distance between the first terminal and the conductive layer which functions as the antenna and the distance between the second terminal and the substrate are almost equal.

According to the invention, an insulating layer formed over an integrated circuit, a first terminal formed on a surface of the insulating layer, a conductive layer which is formed over the first terminal and functions as an antenna electrically connected to the first terminal, a second terminal which is formed of the same layer on the same surface as the first terminal and is electrically isolated from the conductive layer, and a layer of a conductive material which is formed of the same layer on the same surface as the conductive layer which functions as the antenna, and is electrically isolated from the conductive layer which functions as the antenna are included.

According to the invention, an insulating layer formed over an integrated circuit, two first terminals formed on a surface of the insulating layer, a conductive layer which is formed over the first terminal and functions as an antenna electrically connected to the first terminals, and one or more second terminals which are formed of the same layer on the same surface as the first terminals and are electrically connected to the conductive layer are included.

According to the invention, an integrated circuit includes a transistor.

According to the invention, the following are included: a transistor formed over a substrate; a first insulating layer provided over the transistor; a first conductive layer which is connected to a source or a drain of the transistor via an opening provided in the first insulating layer; a second conductive layer provided over the first insulating layer; a second insulating layer provided over the first insulating layer, the first conductive layer, and the second conductive layer; a third conductive layer which is provided so as to fill an opening provided in the second insulating layer and is in contact with the second conductive layer; a layer of a conductive material which is provided over the second insulating layer; and a fourth conductive layer which is electrically connected to the third conductive layer via a conductive material, in which the layer of the conductive material is electrically isolated from the first conductive layer, the second conductive layer, the third conductive layer, and the fourth conductive layer.

According to the invention, the following are included: a transistor formed over a substrate; a first insulating layer provided over the transistor; a first conductive layer which is connected to a source or a drain of the transistor via an opening provided in the first insulating layer; a second conductive layer provided over the first insulating layer; a second insulating layer provided over the first insulating layer, the first conductive layer, and the second conductive layer; a third conductive layer which is provided so as to fill an opening provided in the second insulating layer and is in contact with the second conductive layer; a layer of a conductive material which is provided over the second insulating layer; a fourth conductive layer which is electrically connected to the third conductive layer via a conductive material; and a substrate provided over the fourth conductive layer, in which the layer of the conductive material is electrically isolated from the first conductive layer, the second conductive layer, the third conductive layer, and the fourth conductive layer, and the distance between the third conductive layer and the fourth conductive layer and the distance between the layer of the first conductive material and the substrate are almost equal.

According to the invention, the following are included: a transistor formed over a substrate; a first insulating layer provided over the transistor; a first conductive layer which is connected to a source or a drain of the transistor via an opening provided in the first insulating layer; a second conductive layer provided over the first insulating layer; a second insulating layer provided over the first insulating layer, the first conductive layer, and the second conductive layer; a third conductive layer which is provided so as to fill an opening provided in the second insulating layer and is in contact with the second conductive layer; and a fourth conductive layer which is electrically connected to the third conductive layer via a conductive material, in which a layer of a conductive material is included which is electrically isolated from the first conductive layer, the second conductive layer, the third conductive layer, and the fourth conductive layer, and is provided in the same layer on the same surface as the fourth conductive layer.

According to the invention, the following are included: a transistor formed over a substrate; a first insulating layer provided over the transistor; a first conductive layer which is connected to a source or a drain of the transistor via an opening provided in the first insulating layer; a second conductive layer provided over the first insulating layer; a second insulating layer provided over the first insulating layer, the first conductive layer, and the second conductive layer; a third conductive layer which is provided so as to fill an opening provided in the second insulating layer and is in contact with the second conductive layer; a layer of a first conductive material which is provided over the second insulating layer; a fourth conductive layer which is electrically connected to the third conductive layer via a conductive material; and a layer of a second conductive material which is provided in the same layer on the same surface as the fourth conductive layer, in which the layer of the first conductive material is electrically isolated from the first conductive layer, the second conductive layer, the third conductive layer, and the fourth conductive layer, and the layer of the second conductive material is electrically isolated from the first conductive layer, the second conductive layer, the third conductive layer, and the fourth conductive layer.

According to the invention, the following are included: a transistor formed over a substrate; a first insulating layer provided over the transistor; a first conductive layer which is connected to a source or a drain of the transistor via an opening provided in the first insulating layer; a second conductive layer provided over the first insulating layer; a second insulating layer provided over the first insulating layer, the first conductive layer, and the second conductive layer; three or more third conductive layers which are provided so as to fill an opening provided in the second insulating layer and are in contact with the second conductive layer; and a fourth conductive layer which is electrically connected to the third conductive layers via a conductive material.

By using the structure of the present invention, mechanical strength at a joining point can be improved. Further, by providing three or more terminals, a plane surface can be formed two-dimensionally, thereby the terminal does not become a fulcrum of bending stress, unlike conventionally, even when bending stress is applied to an element (e.g., a transistor included in a semiconductor device), so that the element can be designed without damaging reliability. For example, in the case of three terminals, a triangle plane surface with vertexes of the three terminals can be formed, and thus bending stress applied to the element can be dispersed within the surface.

In addition, by increasing the number of joining terminals according to the structure of the present invention, mechanical strength of joining against bending stress applied from various directions can be improved, and redundancy can also be provided. In addition, in the case of using a terminal which does not affect electrically (a pseudo terminal), the pseudo terminal can be designed at an arbitrary position within the element even when there is area limitation of a wiring or when wirings are provided so as to be concentrated within the element surface, which can contribute to dispersion of stress of an electrical joining terminal. Furthermore, by providing the pseudo terminal so as to be symmetric to the electrical joining terminal, various bending stress can be dispersed, thereby strength can be improved. Further, in a manufacturing step, a load is dispersed evenly to the plurality of terminals even in a pressure bonding method that is a joining method of the element and the antenna, thereby destruction of the element can be suppressed so that the yield can be improved.

### BRIEF DESCRIPTION OF THE DRAWINGS

FIGS. 1A and 1B describe a semiconductor device of the invention.
FIGS. 2A and 2B describe a semiconductor device of the invention.
FIGS. 3A and 3B describe a semiconductor device of the invention.
FIGS. 4A and 4B describe a semiconductor device of the invention.
FIGS. 5A and 5B describe a semiconductor device of the invention.
FIGS. 6A and 6B describe a semiconductor device of the invention.
FIGS. 7A and 7B describe a semiconductor device of the invention.
FIGS. 8A and 8B describe a semiconductor device of the invention.
FIGS. 9A to 9C describe a manufacturing method of a semiconductor device of the invention.
FIGS. 10A and 10B describe a manufacturing method of a semiconductor device of the invention.
FIGS. 11A and 11B describe a manufacturing method of a semiconductor device of the invention.
FIGS. 12A and 12B describe a manufacturing method of a semiconductor device of the invention.
FIGS. 13A and 13B describe a manufacturing method of a semiconductor device of the invention.
FIGS. 14A and 14B describe a manufacturing method of a semiconductor device of the invention.
FIGS. 15A and 15B describe a semiconductor device of the invention.
FIGS. 16A and 16B describe a semiconductor device of the invention.
FIGS. 17A to 17C describe a manufacturing method of a semiconductor device of the invention.
FIGS. 18A and 18B describe a manufacturing method of a semiconductor device of the invention.
FIGS. 19A and 19B describe a manufacturing method of a semiconductor device of the invention.
FIG 20 describes a manufacturing method of a semiconductor device of the invention.
FIGS. 21A to 21E describe an antistatic substrate.
FIG. 22 describes a semiconductor device of the invention.
FIGS. 23A to 23E describe a semiconductor device of the invention.

### DETAILED DESCRIPTION OF THE INVENTION

Although the invention will be described in detail by way of embodiment modes with reference to the accompanying drawings, it is to be understood that various changes and modifications will be apparent to those skilled in the art. Therefore, unless such changes and modifications depart from the scope of the invention, they should be construed as being included therein. Note that in a structure of the present invention described below, the same one is denoted by the same reference numeral in the different drawings.

### (Embodiment Mode 1)

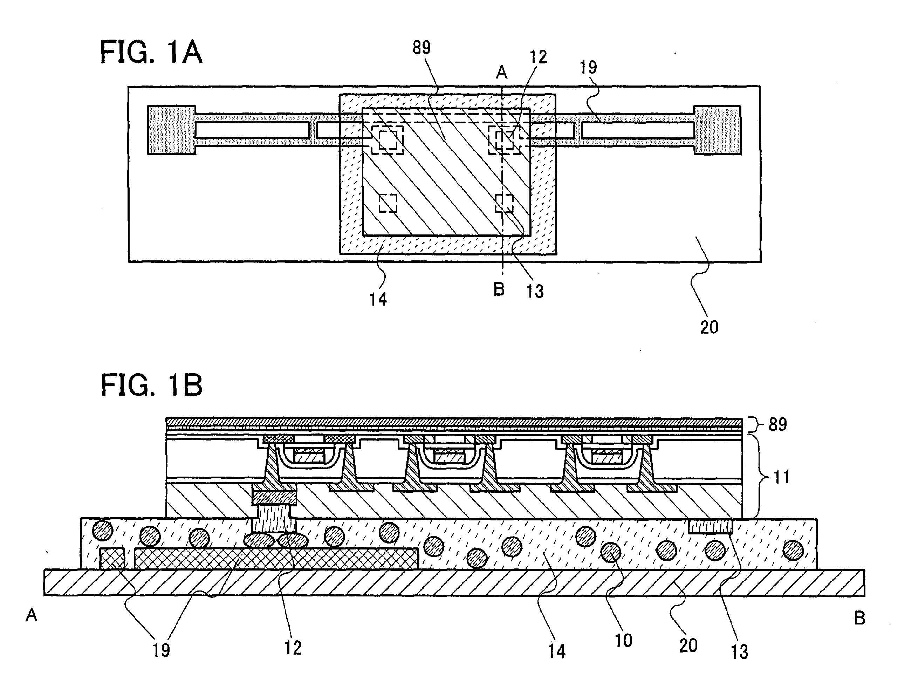

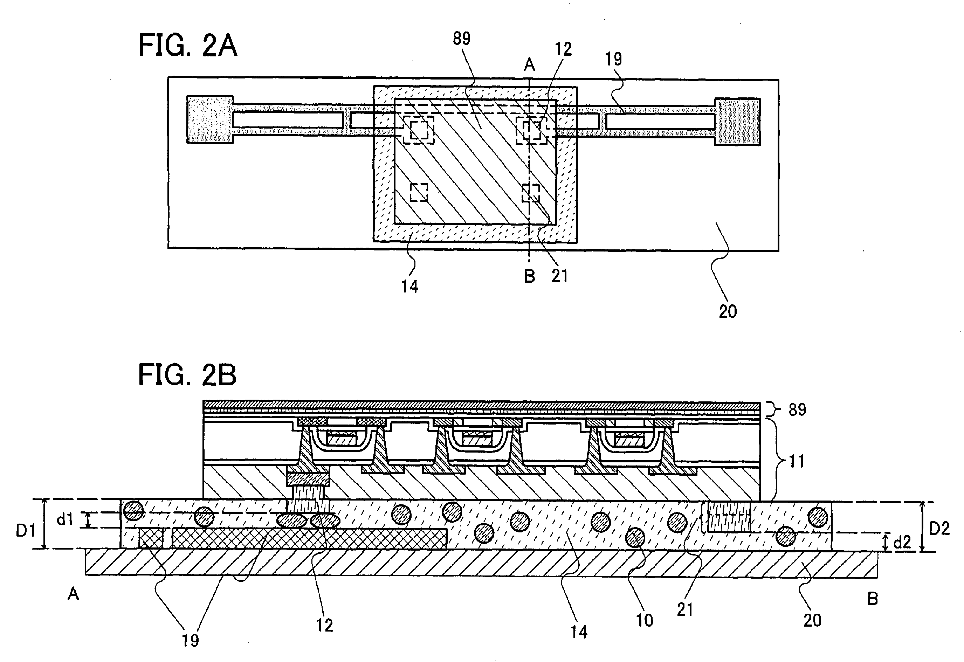

A structure of a semiconductor device in this embodiment mode is described with reference to FIGS. 1A and 1B, and 2A and 2B. FIG. 1B is a cross-sectional diagram along a line A-B of a top diagram of FIG. 1A. FIG. 2B is a cross-sectional diagram along a line A-B of a top diagram of FIG. 2A.

A substrate 89 and a substrate 20 are provided such that one surface of the substrate 89 and one surface of the substrate 20 face each other. On the one surface of the substrate 89, a layer 11 including an integrated circuit is formed (see FIG. 1B and FIG 2B). Over the layer 11 including the integrated circuit, a terminal 12 which is electrically connected to a wiring included in the layer 11 including the integrated circuit is provided. Note that the layer 11 including the integrated circuit includes a plurality of transistors. The terminal 12 is electrically connected to a conductive layer 19 which functions as an antenna formed on the one surface of the substrate 20, via a conductive material (a resin layer 14 containing a conductive particle 10). Note that description is made here of the case where the conductive layer 19 which functions as the antenna is a dipole antenna.

In addition, as shown in FIGS. 1A and 1B, over the layer 11 including the integrated circuit, a terminal 13 (hereinafter, also referred to as a pseudo terminal) which is not electrically connected to (i.e., which is isolated from) the wiring included in the layer 11 including the integrated circuit and the conductive layer 19 which functions as the antenna is included. Note that the number and position of the pseudo terminal of the invention are not limited to the structure shown in the drawing. That is, the position and number of the pseudo terminals can be freely changed as long as the pseudo terminal 13 is provided one or more in number.

By providing the pseudo terminal 13, stress to be applied to the one terminal 12 can be alleviated. That is, in a conventional structure in which the pseudo terminal has not been provided, stress applied to a semiconductor device has been concentrated at a point connected to the terminal 12 and as a result of this, a joining portion (a point at which the terminal 12 and the conductive layer 19 which functions as the antenna are connected to each other) has been destroyed. However, by using the structure of the present invention, the destruction of the joining portion can be suppressed. Consequently, durability can be improved as compared with a conventional semiconductor device. Furthermore, by using the above-described structure, a semiconductor device can be prevented from being destroyed by pressure applied when attaching the joining portion, thereby the yield can be improved.

In addition, the thickness of the pseudo terminal may be, like a pseudo terminal 21 shown in FIG. 2B, equal to the sum of the terminal 12 provided between the layer 11 including the integrated circuit and the substrate 20, and the conductive layer 19 which functions as the antenna as well. That is, a distance (an interval) d 1 between the terminal 12 and the conductive layer 19 which functions as the antenna may be almost equal to a distance (an interval) d2 between the pseudo terminal 21 and the substrate 20 provided on one surface of the conductive layer 19 which functions as the antenna. Note that a distance (an interval) D1 between the substrate 20 and the layer 11 including the thin film integrated circuit in a region where the terminal 12 and the conductive layer 19 which functions as the antenna are formed is almost equal to a distance (an interval) D2 between the substrate 20 and the layer 11 including the thin film integrated circuit in a region where the pseudo terminal 21 is formed.

By using such a structure, since external force to be applied to one terminal can be further dispersed, external force applied to an electrical joining terminal can be alleviated more than the case in the structure shown in FIGS. 1A and 1B. That is, destruction of a joining portion can be suppressed and strength can be improved, thereby the yield can be improved.

### (Embodiment Mode 2)

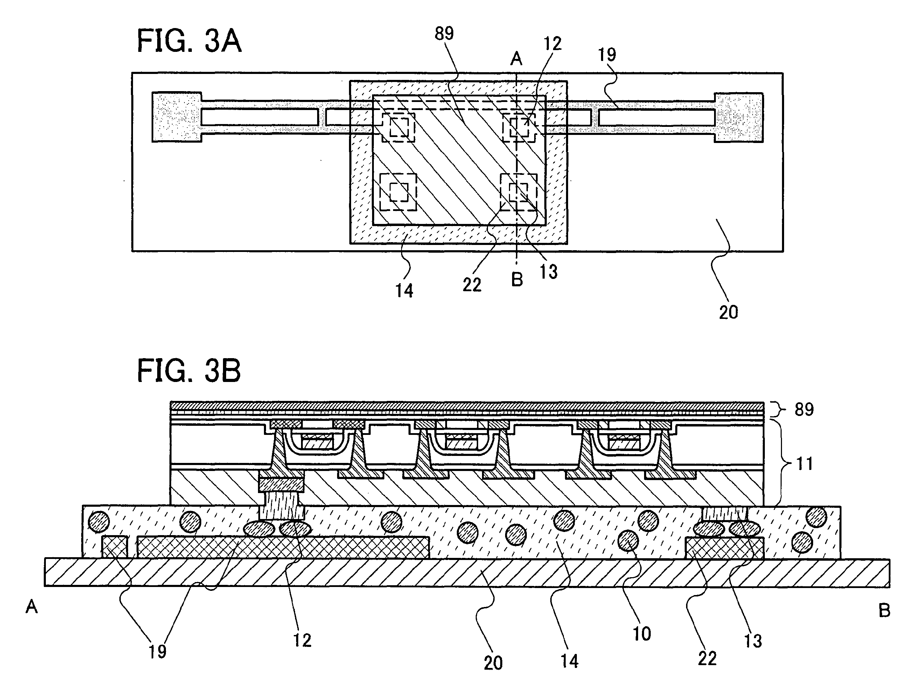

This embodiment mode describes a structure of a semiconductor device of which the shape is different from the semiconductor device described in Embodiment Mode 1, with reference to FIGS. 3A and 3B. This embodiment mode is different from the structure described in Embodiment Mode 1 in that a layer formed of a conductive material is provided in addition to a conductive layer which functions as an antenna, for a substrate provided with the conductive layer which functions as the antenna on one surface thereof. Note that description of the same points as Embodiment Mode 1 is omitted.

As shown in FIGS. 3A and 3B, an element of the invention includes the pseudo terminal 13 over the layer 11 including the integrated circuit. Note that the number and position of the pseudo terminals of the invention are not limited to the structure shown in the drawing. That is, the position and number of the pseudo terminals can be freely changed as long as the pseudo terminal 13 is provided one or more in number. Note that description is made here of the case where the conductive layer 19 which functions as the antenna is a dipole antenna.

In addition, on the surface of the substrate 20 provided with the conductive layer 19 which functions as the antenna, a layer (hereinafter abbreviated as a pseudo conductive layer 22) formed of a conductive material which is not electrically connected to (i.e., which is isolated from) the conductive layer 19 which functions as the antenna and the wiring included in the layer 11 including the integrated circuit is provided. Note that the number, position, and shape of the pseudo conductive layer of the invention are not limited to the structure shown in the drawing. Here, the pseudo conductive layer 22 is provided so as to face the pseudo terminal 13.

By providing the pseudo terminal 13 and the pseudo conductive layer 22, stress to be applied to the one terminal 12 can be alleviated. That is, in a conventional structure in which the pseudo terminal and the pseudo conductive layer have not been provided, stress applied to a semiconductor device has been concentrated at a point connected to the terminal 12 and as a result of this, a joining portion (a point at which the terminal 12 and the conductive layer 19 which functions as the antenna are electrically connected to each other) has been destroyed. However, by using the structure of the invention, the destruction of the joining portion can be suppressed. Consequently, strength can be improved as compared with a conventional semiconductor device, thereby the yield can be improved.

By using such a structure, since stress to be applied to the terminal 12 can be further dispersed by the pseudo terminal 13 and the pseudo conductive layer 22, stress applied to an electrical joining terminal can be alleviated more than the case in the structure described in Embodiment Mode 1. That is, destruction of a joining portion can be suppressed and strength can be improved. Furthermore, by using the above-described structure, a semiconductor device can be prevented from being destroyed by pressure applied when attaching the joining portion, thereby the yield can be improved.

Note that although the description is made of the structure in which the pseudo terminal and the pseudo conductive layer are provided, a structure in which only the pseudo conductive layer is provided may also be used.

### (Embodiment Mode 3)

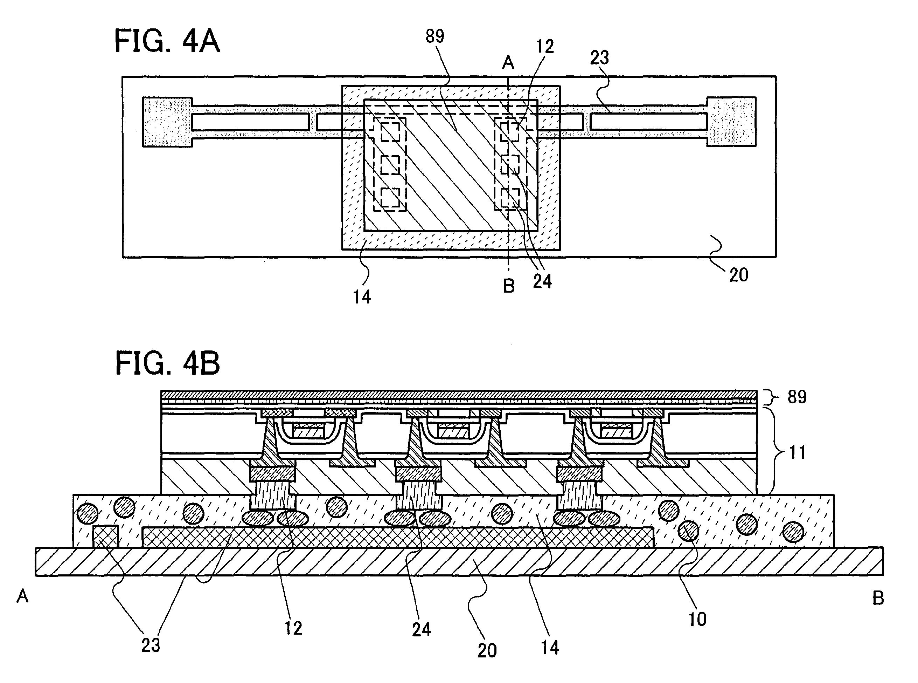

An embodiment mode of the invention is described with reference to FIGS. 4A and 4B. This embodiment mode describes a structure of a semiconductor device of which the shape is different from those of Embodiment Mode 1 and Embodiment Mode 2. This embodiment mode is different from Embodiment Mode 1 and Embodiment Mode 2 in the shape of the conductive layer which functions as the antenna and in that a plurality of terminals (hereinafter abbreviated as auxiliary terminals) which are electrically connected to the conductive layer which functions as the antenna, in addition to the terminal which is electrically connected to the conductive layer which functions as the antenna are provided. Note that description of the same points as Embodiment Mode 1 is omitted.

As shown in FIGS. 4A and 4B, over the layer 11 including the integrated circuit, an auxiliary terminal 24 which is electrically connected to both of the wiring included in the layer 11 including the integrated circuit and a conductive layer 23 that is part of the conductive layer which functions as the antenna is included. Note that the number of the auxiliary terminals of the invention is not limited to the structure shown in the drawing. That is, the position and number of the auxiliary terminals can be freely changed as long as the auxiliary terminal 24 is provided one or more in number. In other words, the terminal 12 and the auxiliary terminal 24 are included three or more in total number. Note that description is made here of the case where the conductive layer 23 which functions as the antenna is a dipole antenna.

By providing the auxiliary terminal 24, stress to be applied to the one terminal 12 can be alleviated. That is, in a conventional structure in which the auxiliary terminal has not been provided, stress applied to a semiconductor device has been concentrated at a point connected to the terminal 12 and as a result of this, a joining portion (a point at which the terminal 12 and the conductive layer 23 are electrically connected to each other) has been destroyed. However, by using the structure of the invention, the destruction of the joining portion can be suppressed, thereby the strength can be improved.

Further, by using the semiconductor device with the structure of the invention, even when a joining portion between the terminal 12 and the conductive layer 23 is destroyed, the semiconductor device can be operated unless an electrical joining point between the auxiliary terminal 24 and the conductive layer 23 is destroyed. Consequently, the yield can be improved as compared with a conventional semiconductor device. In addition, by using the above-described structure, the semiconductor device can be prevented from being destroyed by pressure applied to the semiconductor device in attaching the joining portion, thereby improving the yield.

### (Embodiment Mode 4)

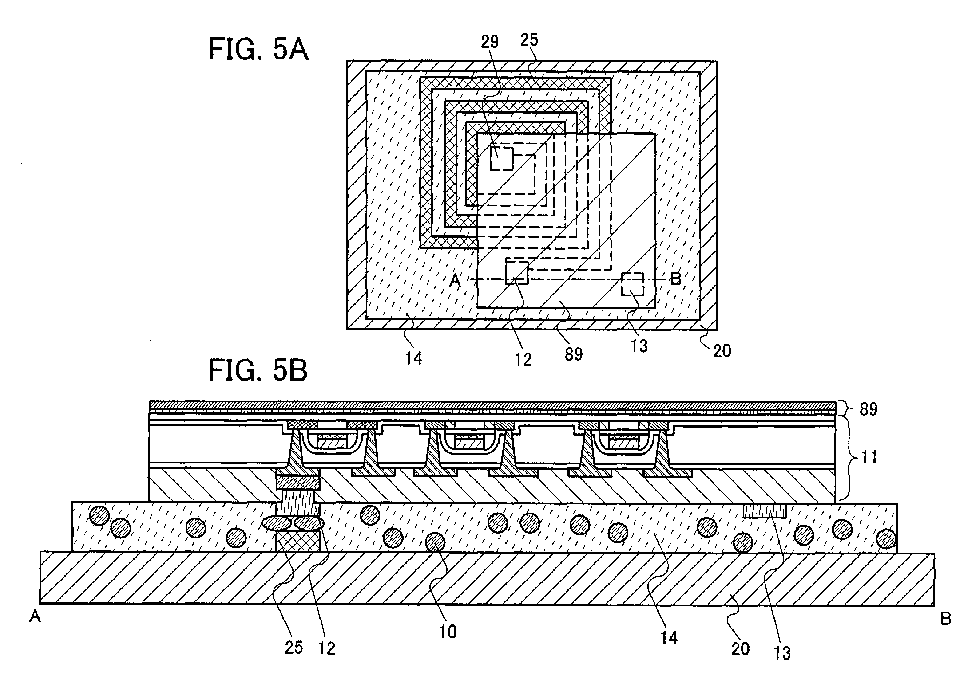

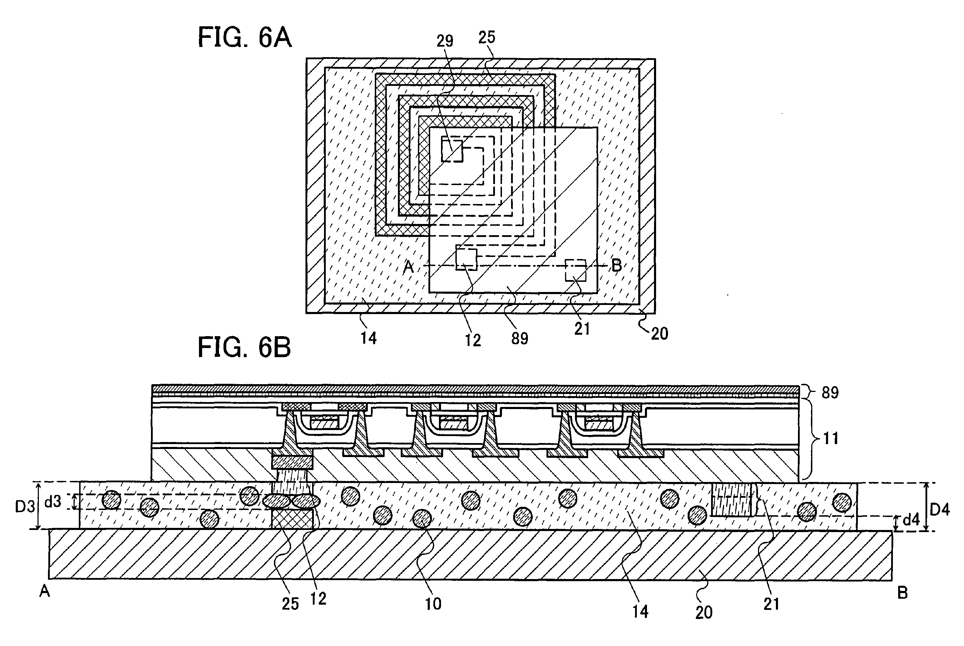

This embodiment mode describes a structure of a semiconductor device having a conductive layer which functions as an antenna, which is different from the semiconductor devices described in Embodiment Modes 1 to 3, with reference to FIGS. 5A and 5B, and 6A and 6B. FIGS. 5A and 6A are top diagrams of semiconductor devices respectively. FIG 5B is a cross-sectional diagram along a line A-B of FIG. 5A. FIG 6B is a cross-sectional diagram along a line A-B of the top diagram of FIG. 6A.

The substrate 89 and the substrate 20 are provided such that one surface of the substrate 89 and one surface of the substrate 20 face each other. On the one surface of the substrate 89, the layer 11 including the integrated circuit is formed (see FIGS. 5B and 6B). Over the layer 11 including the integrated circuit, the terminal 12 and a terminal 29 which are electrically connected to the wiring included in the layer 11 including the integrated circuit are provided. Note that the layer 11 including the integrated circuit includes a plurality of transistors. The terminal 12 is electrically connected to a conductive layer 25 which functions as an antenna formed on the one surface of the substrate 20, via a conductive material (a resin layer 14 containing a conductive particle 10). Note that description is made here of the case where the conductive layer 25 which functions as the antenna is a loop antenna.

In addition, as shown in FIGS. 5A and 5B, over the layer 11 including the integrated circuit, the pseudo terminal 13 which is not electrically connected to (i.e., which is isolated from) the wiring included in the layer 11 including the integrated circuit and the conductive layer 25 which functions as the antenna is included. Note that the invention is not limited to the structure shown in the drawing. That is, the position and number of the pseudo terminals can be freely changed as long as the pseudo terminal 13 is provided one or more in number.

By providing the pseudo terminal 13, stress to be applied to the one terminal 12 can be alleviated. That is, in a conventional structure in which the pseudo terminal has not been provided, stress applied to a semiconductor device has been concentrated at a point connected to the terminal 12 and as a result of this, a joining portion (a point at which the terminal 12 and the conductive layer 25 which functions as the antenna are electrically connected to each other) has been destroyed. However, by using the structure of the invention, the destruction of the joining portion can be suppressed. Consequently, the yield can be improved as compared with the conventional semiconductor device.

In addition, the thickness of the pseudo terminal may be, like the pseudo terminal 21 shown in FIG. 6B, equal to the sum of the terminal 12 provided between the layer 11 including the integrated circuit and the substrate 20, and the conductive layer 25 which functions as the antenna. That is, a distance (an interval) d3 between the terminal 12 and the conductive layer 25 which functions as the antenna may be almost equal to a distance (an interval) d4 between the pseudo terminal 21 and the substrate 20 provided with the conductive layer 25 which functions as the antenna on one surface of the substrate 20. Note that a distance (an interval) D3 between the substrate 20 and the layer 11 including the thin film integrated circuit in a region where the terminal 12 and the conductive layer 25 which functions as the antenna are formed is almost equal to a distance (an interval) D4 between the substrate 20 and the layer 11 including the thin film integrated circuit in a region where the pseudo terminal 13 is formed.

By using such a structure, stress to be applied to the one terminal 12 can be alleviated more than the case in the structure shown in FIGS. 5A and 5B. That is, destruction of a joining portion can be suppressed and strength can be improved, thereby the yield can be improved. In addition, by using the above-described structure, the semiconductor device can be prevented from being destroyed by pressure applied to the semiconductor device in attaching the joining portion, thereby improving the yield.

Note that the shape of the antenna is not limited to this; a wiring may be connected to the conductive layer 25 which functions as the antenna and the terminals 12 and 29 may be formed side-by-side.

### (Embodiment Mode 5)

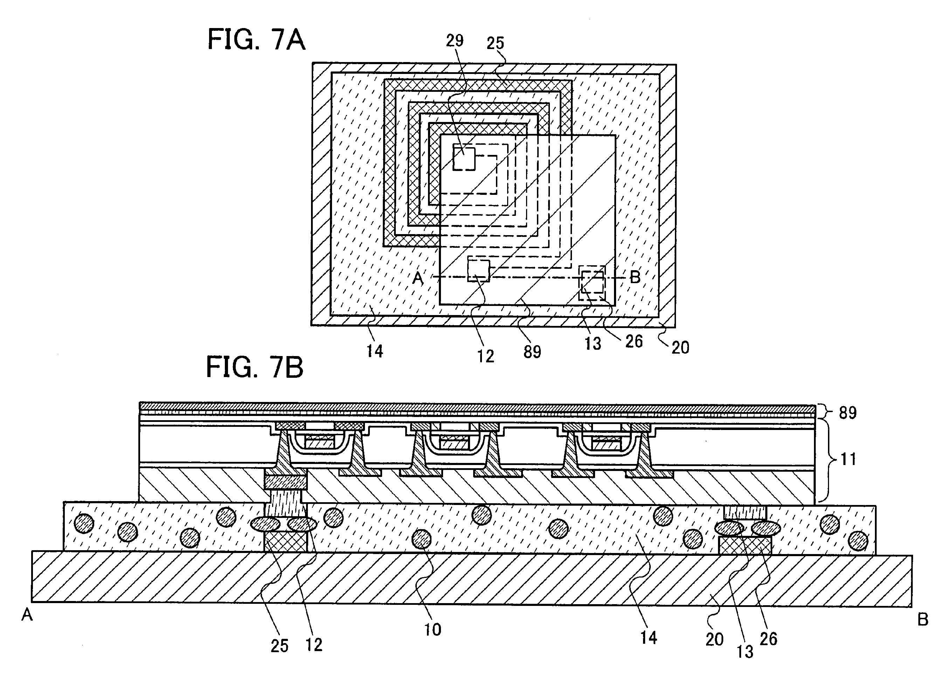

This embodiment mode describes a structure of a semiconductor device in which a conductive material is provided for a substrate provided with a conductive layer which functions as an antenna on one surface, in addition to the conductive layer which functions as the antenna, with reference to FIGS. 7A and 7B. Note that description of the same points as Embodiment Modes 1 to 4 is omitted.

FIG. 7A is a top diagram of the semiconductor device and FIG. 7B is a cross-sectional diagram along a line A-B of FIG 7A. As shown in FIGS. 7A and 7B, the pseudo terminal 13 is provided over the layer 11 including the integrated circuit. Note that the number and position of the pseudo terminals of the invention are not limited to the structure shown in the drawing. That is, the position and number of the pseudo terminals can be freely changed as long as the pseudo terminal 13 is provided one or more in number. Note that description is made here of the case where the conductive layer 25 which functions as the antenna is a loop antenna.

In addition, a pseudo conductive layer 26 is provided on the surface of the substrate 20 provided with the conductive layer 25 which functions as the antenna. Note that the number, position, and shape of the pseudo conductive layers of the invention are not limited to the structure shown in the drawing. Here, the pseudo conductive layer 26 is provided so as to face the pseudo terminal 13.

By providing the pseudo terminal 13 and the pseudo conductive layer 26, destruction of a joining portion between the conductive layer 25 and the terminal 12 can be suppressed. Consequently, strength can be improved as compared with a conventional semiconductor device, thereby the yield can be improved.

By using such a structure, stress to be applied to an electrical joining terminal can be alleviated more than the case in the structure described in Embodiment Mode 4. That is, destruction of a joining portion can be suppressed and the yield can be improved. Furthermore, by using the above-described structure, a semiconductor device can be prevented from being destroyed by pressure applied to the semiconductor device when attaching the joining portion, thereby the yield can be improved.

Note that the shape of the antenna is not limited to this; a wiring may be connected and the terminals 12 and 29 may be formed side-by-side.

### (Embodiment Mode 6)

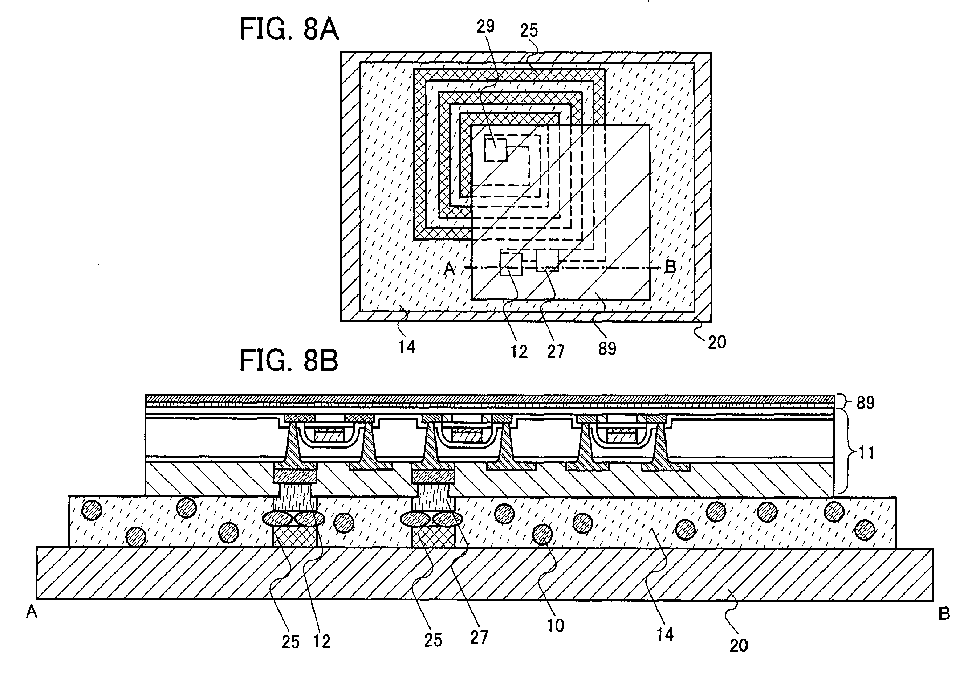

An embodiment mode of the invention is described with reference to FIGS. 8A and 8B. This embodiment mode describes the shape of a conductive layer which functions as an antenna and a structure of a semiconductor device in which a plurality of auxiliary terminals are provided in addition to a terminal electrically connected to the conductive layer which functions as the antenna. Note that description of the same points as Embodiment Modes 1 to 5 is omitted.

FIG. 8A is a top diagram of the semiconductor device and FIG. 8B is a cross-sectional diagram along a line A-B of FIG 8A. As shown in FIGS. 8A and 8B, an auxiliary terminal 27 is provided which is electrically connected to the wiring included in the layer 11 including the integrated circuit and the conductive layer 25 which functions as the antenna, over the layer 11 including the integrated circuit. Note that the number of the auxiliary terminals of the invention is not limited to the structure shown in the drawing. That is, the position and number of the auxiliary terminals can be freely changed as long as the auxiliary terminal 27 is provided one or more in number. In other words, the terminal and the auxiliary terminal are included three or more in total number.

By providing the auxiliary terminal 27, destruction of a joining portion between the conductive layer 25 and the terminal 12 can be suppressed. Consequently, as compared with a conventional semiconductor device, strength can be improved,and the yield can be improved.

Further, by using the semiconductor device with the structure of the invention, even when a joining portion of the terminal 12 is destroyed, the semiconductor device can be operated unless an electrical joining point between the auxiliary terminal 27 and the conductive layer 25 which functions as the antenna is destroyed. Consequently, the yield can be improved as compared with a conventional semiconductor device.

Note that the shape of the antenna is not limited to this; a wiring may be connected and the terminals 12 and 29 may be formed side-by-side.

Note that the kind of the antenna is not limited to the shapes (kinds) described in Embodiment Modes 1 to 6. For example, a spiral or a flat rectangular solid (e.g., a patch antenna) may be used. In addition, the antenna may have a multi-layer structure. It is to be understood that various changes into another shape will be apparent to those skilled in the art.

### (Embodiment Mode 7)

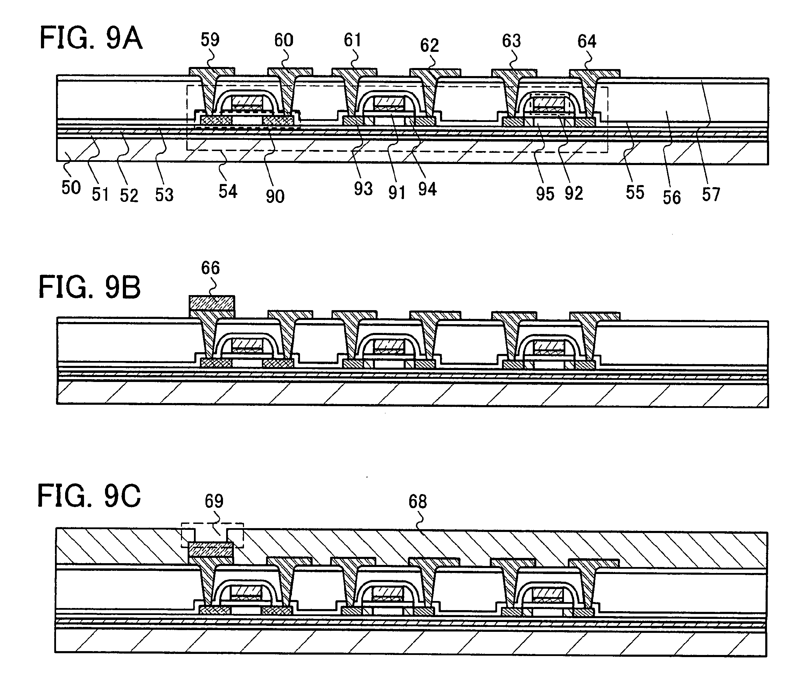

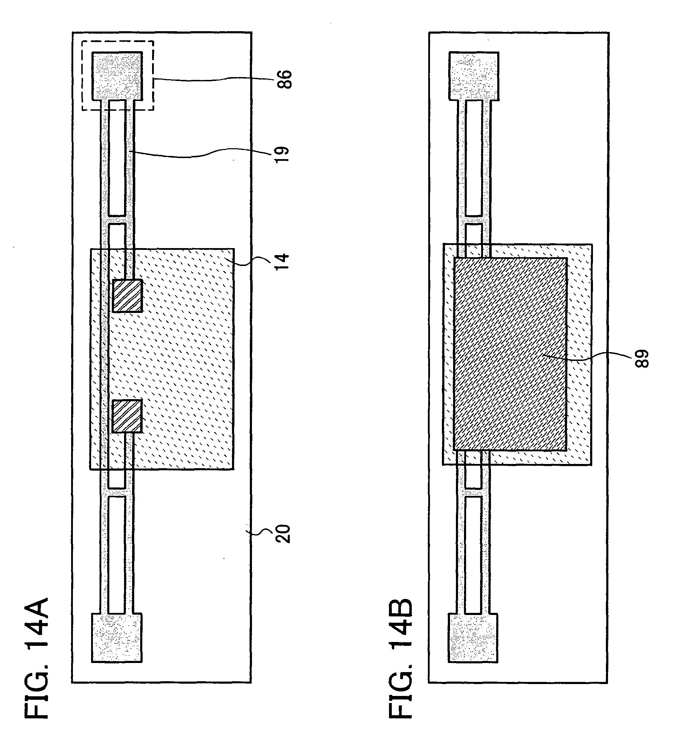

A manufacturing method of a semiconductor device of the invention is described with reference to cross-sectional diagrams of FIGS. 9A and 9B, 9C, 10A and 10B, 11A and 11B, 12A and 12B, and 13A and 13B and top diagrams of FIGS. 14A and 14B. Here, description is made of a manufacturing method of the semiconductor device shown in FIGS. 1A and 1B.

First, an insulating layer 51 is formed over one surface of a substrate 50 (see FIG 9A). Next, a release layer 52 is formed over the insulating layer 51. Then, an insulating layer 53 is formed over the release layer 52.

The substrate 50 is a substrate having an insulating surface and is, for example, a glass substrate, a plastic substrate, a quartz substrate, or the like. As the substrate 50, either a glass substrate or a plastic substrate is preferably used. This is because a glass substrate or a plastic substrate having a side of 1 meter or more and/or having a desired shape such as a square can be easily manufactured. Thus, when a glass substrate or a plastic substrate which has a square shape and has a side of 1 meter or more is used for example, productivity can be drastically improved. This is a great advantage compared with the case of using a silicon substrate having a circular shape with a diameter of about 30 centimeters at maximum.

The insulating layers 51 and 53 are formed by vapor deposition (CVD) or sputtering by using oxide or nitride of silicon, oxide of silicon containing nitrogen, nitride of silicon containing oxygen, or the like. The insulating layer 51 prevents impurity elements from entering an upper layer from the substrate 50. The insulating layer 51 is not necessarily formed if not required.

The release layer 52 is formed by sputtering or the like with a single layer or a multi-layer of a layer containing an element selected from tungsten (W), molybdenum (Mo), titanium (Ti), tantalum (Ta), niobium (Nb), nickel (Ni), cobalt (Co), zirconium (Zr), zinc (Zn), ruthenium (Ru), rhodium (Rh), palladium (Pd), osmium (Os), iridium (Ir), silicon (Si), or the like or an alloy material or a compound material containing the above described element as its main component. Note that the layer containing silicon may have any of the amorphous, microcrystalline, or polycrystalline structure.

In the case where the release layer 52 has a single-layer structure, a layer containing any one of the following may be preferably formed: tungsten, molybdenum, a mixture of tungsten and molybdenum, oxide of tungsten, oxynitride of tungsten, nitride oxide of tungsten, oxide of molybdenum, oxynitride of molybdenum, nitride oxide of molybdenum, oxide of a mixture of tungsten and molybdenum, oxynitride of a mixture of tungsten and molybdenum, and nitride oxide of a mixture of tungsten and molybdenum.

In the case where the release layer 52 has a multi-layer structure, a layer containing tungsten, molybdenum, or a mixture of tungsten and molybdenum may be preferably formed as a first layer. As a second layer, a layer containing oxide of tungsten, oxide of molybdenum, oxide of a mixture of tungsten and molybdenum, oxynitride of tungsten, oxynitride of molybdenum, or oxynitride of a mixture of tungsten and molybdenum may be preferably formed.

In the case where a multi-layer structure of tungsten and oxide of tungsten is formed as the release layer 52, a layer containing tungsten may be formed as the release layer 52 first, and then a layer containing oxide of silicon may be formed as the insulating layer 53 so that a layer containing oxide of tungsten is formed at the interface between the layer containing tungsten and the layer containing oxide of silicon. The same can be applied to the case of forming a layer containing nitride, oxynitride, or nitride oxide of tungsten, or the like; after a layer containing tungsten is formed, a layer containing nitride of silicon, a silicon nitride layer containing oxygen, or a silicon oxide layer containing nitrogen may be formed thereover.

Subsequently, a plurality of transistors 54 are formed over the insulating layer 53. In this step, thin film transistors are formed as the plurality of transistors 54.

Each of the plurality of transistors 54 includes a semiconductor layer 90, a gate insulating layer (also called merely an insulating layer) 91, and a conductive layer 92 which is a gate (also called a gate electrode). The semiconductor layer 90 includes impurity regions 93 and 94 functioning as a source or a drain, and a channel formation region 95. The impurity regions 93 and 94 are doped with an impurity element which imparts n-type (e.g., phosphorus: P or arsenic: As) or an impurity element which imparts p-type (e.g., boron: B). The impurity region 94 is an LDD (Lightly Doped Drain) region.

Each of the plurality of transistors 54 may have either of a top-gate structure in which the gate insulating layer 91 is provided over the semiconductor layer 90 and the conductive layer 92 is provided over the gate insulating layer 91, or a bottom-gate structure in which the gate insulating layer 91 is provided over the conductive layer 92 and the semiconductor layer 90 is provided over the gate insulating layer 91. Further, each of one or more of the plurality of transistors 54 may be a multi-gate transistor in which two or more gate electrodes and two or more channel formation regions are provided.

Note that although only the plurality of transistors 54 are formed over the substrate 50 here, the invention is not limited to this structure. An element to be provided over the substrate 50 may be appropriately adjusted in accordance with the use application of the semiconductor device. For example, in the case of forming a semiconductor device having a function of sending and receiving data without contact, only a plurality of transistors, or a plurality of transistors and a conductive layer which functions as an antenna may be formed over the substrate 50. In addition, in the case of forming a semiconductor device having a function of storing data, a plurality of transistors and a memory element (e.g., a transistor or a memory transistor) may be formed over the substrate 50. Further, in the case of forming a semiconductor device having a function of controlling a circuit, generating a signal, or the like (e.g., a CPU or a signal generation circuit), a transistor may be formed over the substrate 50. In addition, another element such as a resistor or a capacitor may be formed if necessary.

Then, over the plurality of transistors 54, insulating layers 55 to 57 are formed. The insulating layers 55 to 57 are formed by vapor deposition, sputtering, SOG (Spin On Glass), droplet discharge (e.g., ink jetting), or the like by using oxide of silicon, nitride of silicon, polyimide, acrylic, siloxane, oxazole resin, or the like. Siloxane includes a skeleton formed by the bond of silicon and oxygen, in which an organic group containing at least hydrogen (e.g., an alkyl group or aromatic hydrocarbon) or a fluoro group is included as a substituent. Alternatively, a fluoro group and an organic group containing at least hydrogen may be used as the substituents. Oxazole resin is, for example, photosensitive polybenzoxazole. The oxazole resin which is lower in the relative permittivity (about 2.9) than the relative permittivity of polyimide or the like (about 3.2 to 3.4) can suppress generation of parasitic capacitance and can perform high-speed operation.

In the above-described structure, three insulating layers (the insulating layers 55 to 57) are formed over the plurality of transistors 54; however, the invention is not limited thereto. The number of insulating layers provided over the plurality of transistors 54 is not particularly limited.

Then, openings are formed in the insulating layers 55 to 57, and conductive layers 59 to 64 each connected to a source (also called a source region or a source electrode) or a drain (also called a drain region or a drain electrode) of each of the plurality of transistors 54 (see FIG. 9A) are formed. The conductive layers 59 to 64 are provided in the same layer. In addition, each of the conductive layers 59 to 64 is a source or drain wiring. Signals supplied from external are supplied to the plurality of transistors 54 through the conductive layers 59 to 64.

By sputtering or the like, the conductive layers 59 to 64 are formed with a single layer or a multi-layer of the following: an element selected from titanium, tungsten, chromium, aluminum, tantalum, nickel, zirconium, hafnium, vanadium, iridium, niobium, lead, platinum, molybdenum, cobalt, rhodium, or the like; an alloy material containing the element as its main component; or a compound material of oxide or nitride containing the element as its main component. As an example of the multi-layer structure of each of the conductive layers 59 to 64, there are a three-layer structure of titanium, aluminum, and titanium, a five-layer structure of titanium, titanium nitride, aluminum, titanium, and titanium nitride, a five-layer structure of titanium, titanium nitride, aluminum added with silicon, titanium, and titanium nitride, and the like.

Next, a conductive layer 66 is formed over the conductive layer 59 (see FIG. 9B). A layer containing gold, silver, or copper is formed by screen printing, droplet discharge, or the like as the conductive layer 66. Preferably, the conductive layer 66 may be formed using a paste containing fine particles of silver (a material in which fine particles of silver and resin are mixed) by screen printing. This is because screen printing can shorten manufacturing time and apparatus cost thereof is low. In addition, silver is low in the resistance value.

Then, laser beam irradiation is performed with a laser beam that can dissolve one or both of the conductive layers 66 and 59. Although the conductive layers 66 and 59 are partially in contact with each other before performing the laser beam irradiation, the portion where the conductive layers 66 and 59 are in contact with each other can be increased by the laser beam irradiation. Therefore, more secured electrical connection between the conductive layers 66 and 59 can be obtained; thus, reliability can be improved. As the laser, there are a gas laser, a liquid laser, and a solid state laser when classified by a medium; and a free electron laser, a semiconductor laser, and an X-ray laser when classified by a characteristic of oscillation; however, any of the lasers may be used in the invention. Preferably, a gas laser or a solid state laser may be used, and more preferably, a solid state laser may be used. Furthermore, either of a continuous wave laser or a pulsed laser may be used in the invention.

Next, an insulating layer 68 is selectively formed over the insulating layer 57 and the conductive layers 59 to 64 (see FIG. 9C). The insulating layer 68 is provided with an opening 69. The conductive layer 66 is exposed through the opening 69.

Note that the opening 69 preferably does not have such a shape that the surface of the conductive layer 66 is entirely exposed but has such a shape that the surface of the conductive layer 66 is partially exposed. Specifically, the opening 69 preferably has such a shape that a center portion of the conductive layer 66 is exposed. This is because transposition at an accurate position with a high yield can be performed in a later step. If the insulating layer 68 is provided so as to entirely expose one surface of the conductive layer 66, a region where both of the conductive layer 66 and the insulating layer 68 are not provided may be formed. In the later transposition step, transposition is performed by adhesion between the insulating layer 68 and a substrate 88; therefore, when there is a region where none of the conductive layer 66 and the insulating layer 68 is provided, transposition cannot be performed at an accurate position with a high yield in some cases. However, in the above-described step, the insulating layer 68 is selectively provided so as to expose the center portion of the conductive layer 66. Accordingly, there is no region where none of the conductive layer 66 and the insulating layer 68 is provided; thus, transposition can be performed accurately.

The insulating layer 68 is formed of an insulating resin such as an epoxy resin, an acrylic resin, or a polyimide resin to have a thickness of 5 to 200 µm, preferably 15 to 35 µm. In addition, the insulating layer 68 is formed uniformly by using screen printing, droplet discharge, or the like. Preferably, screen printing is used. This is because screen printing can shorten manufacturing time and apparatus cost thereof is low. Then, heat treatment is performed if necessary.

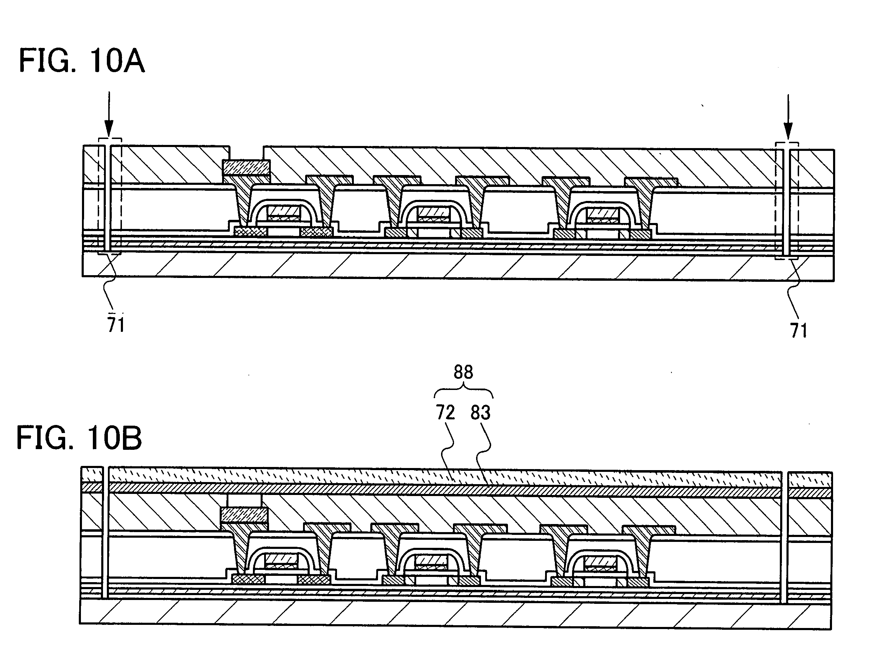

Then, an opening 71 is formed so as to expose at least part of the release layer 52 (see FIG 10A). In terms of short processing time, this step may preferably be carried out by laser beam irradiation. Laser beam irradiation is performed to the substrate 50, the insulating layer 51, the release layer 52, and the insulating layers 53, 55 to 57, and 68; the surface of the insulating layer 68 is irradiated first with a laser beam. The opening 71 is formed so as to expose at least part of the release layer 52. Therefore, the opening 71 is provided at least in the insulating layers 53, 55 to 57, and 68. The structure shown in the drawing is the case where a laser beam reaches up to the insulating layer 51, and the insulating layers 51, 53, 55 to 57, and 68 are sectioned. Note that the laser beam may reach up to the substrate 50.

In the step of irradiation of the above-described laser beam, ablation processing is used. In the ablation processing, a phenomenon is used in which a molecular bond in a portion irradiated with a laser beam, that is, a portion which has absorbed a laser beam is cut, photolyzed, and vaporized. In other words, a molecular bond in a certain portion of the insulating layer 51, the release layer 52, and the insulating layers 53, 55 to 57, and 68 is cut by the laser beam irradiation, and photolyzed and vaporized to form the opening 71.

In addition, as a laser, a solid state laser with a wavelength of 150 to 380 nm that is an ultraviolet region is preferably used. More preferably, an Nd: YVO₄ laser with a wavelength of 150 to 380 nm may be used. This is because, as for the Nd: YVO₄ laser with a wavelength of 150 to 380 nm, light is easily absorbed in the substrate compared with other lasers on longer wavelength side, and ablation processing is possible. Moreover, the periphery of a processed portion is not affected and processability is good.

Next, the substrate 88 is provided over the insulating layer 68 (see FIG 10B). The substrate 88 is a substrate in which an insulating layer 72 and an adhesive layer 83 are stacked, which is a substrate of a heat-peeling type. The adhesive layer 83 is a layer the adhesivity of which decreases by heat treatment, which is, for example, a layer formed of a material utilizing softening of a thermoplastic adhesive at the time of heating, a layer formed of a material where a microcapsule that expands by heating or a foaming agent is mixed, a layer formed of a material in which thermal meltability or a pyrolytic property is given to a thermosetting resin, or a layer using deterioration of interface intensity because of penetration of moisture or expansion of a water-absorbing resin because of the deterioration.

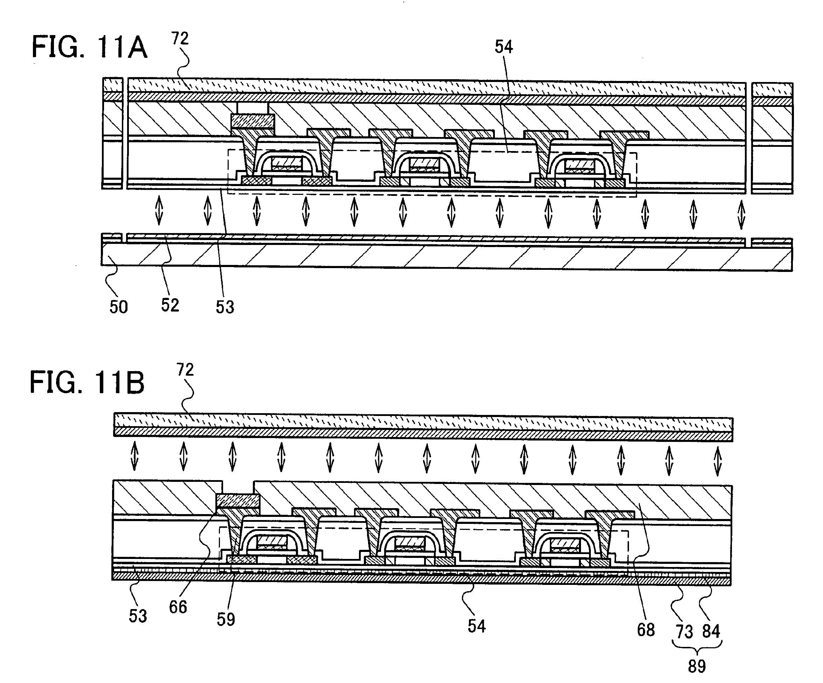

Then, using the substrate 88, the stacked body including the plurality of transistors 54 is separated from the substrate 50 (see FIG. 11A). The separation of the stacked body including the plurality of transistors 54 from the substrate 50 is performed either inside the release layer 52 or at the interface between the release layer 52 and the insulating layer 53 as a boundary. The structure shown in the drawing is the case where the separation is performed at the interface between the release layer 52 and the insulating layer 53 as a boundary. In this manner, the separation step can be performed easily in short time by using the substrate 88.

Next, as well as a substrate 89 is provided on the surface of the insulating layer 53, the stacked body including the plurality of transistors 54 is separated from the substrate 88 by heat treatment (see FIG. 11B). The substrate 89 is a substrate in which an insulating layer 73 and an adhesive layer 84 are stacked. The adhesive layer 84 is a layer the adhesivity of which increases by heat treatment, which corresponds to a layer containing a thermoplastic resin. The thermoplastic resin corresponds to polyethylene, polystyrene, polypropylene, polyvinyl chloride, or the like.

As described above, since the substrate 88 is the substrate of a heat-peeling type, the adhesivity between the substrate 88 and the insulating layer 68 decreases by heat treatment; thus, the stacked body including the plurality of transistors 54 is separated from the substrate 88. At the same time, the thermosetting resin on the surface of the substrate 89 is cured by the heat treatment; thus, the adhesivity between the insulating layer 53 and the one surface of the substrate 89 increases. In this manner, the step of separating the stacked body from the substrate 88 and the step of providing the stacked body over the substrate 89 can be carried out at the same time by using the two substrates 88 and 89 provided with the adhesive layers having different properties. Consequently, manufacturing time can be shortened.

Then, the conductive layer 66 is irradiated again with a laser beam if necessary. This is performed in order to improve defective electrical connection between the conductive layer 59 and the conductive layer 66 that may be caused by the above separation step. Thus, the step of laser beam irradiation is not necessarily performed if not necessary.

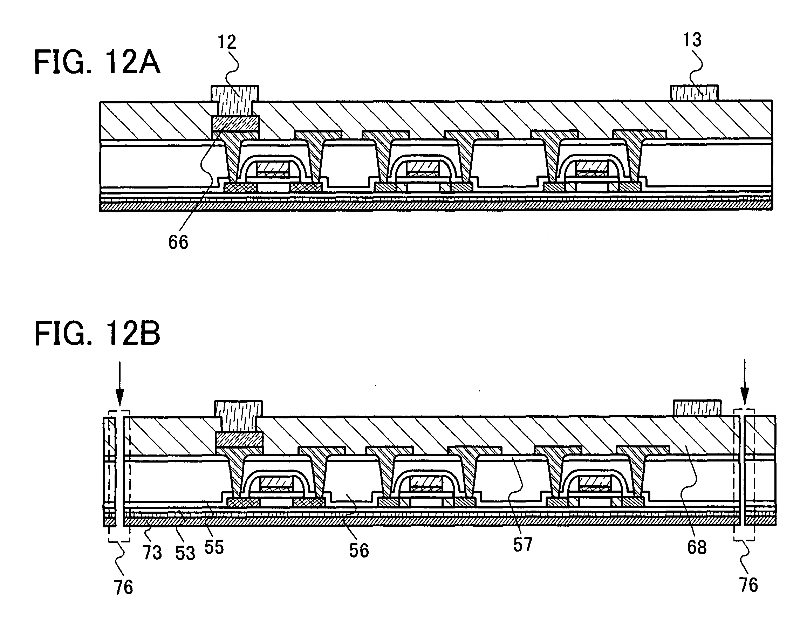

Next, as well as the terminal 12 is formed so as to be in contact with the conductive layer 66, a terminal (the pseudo terminal 13) which is not electrically connected to (i.e., which is isolated from) the wiring over the insulating layer 68 is formed (see FIG 12A). As the terminal 12 and the pseudo terminal 13, a layer containing gold, silver, or copper is formed by screen printing, droplet discharge, or the like. Preferably, they may be formed of a paste containing fine particles of silver (a material in which fine particles of silver and resin are mixed) by screen printing. This is because screen printing can shorten manufacturing time and apparatus cost thereof is low. In addition, silver is low in the resistance value. Then, heat treatment is performed if necessary.

Then, laser beam irradiation is performed to the substrate 49, and the insulating layers 53, 55 to 57, and 68 so that an opening 76 is formed (see FIG 12B).

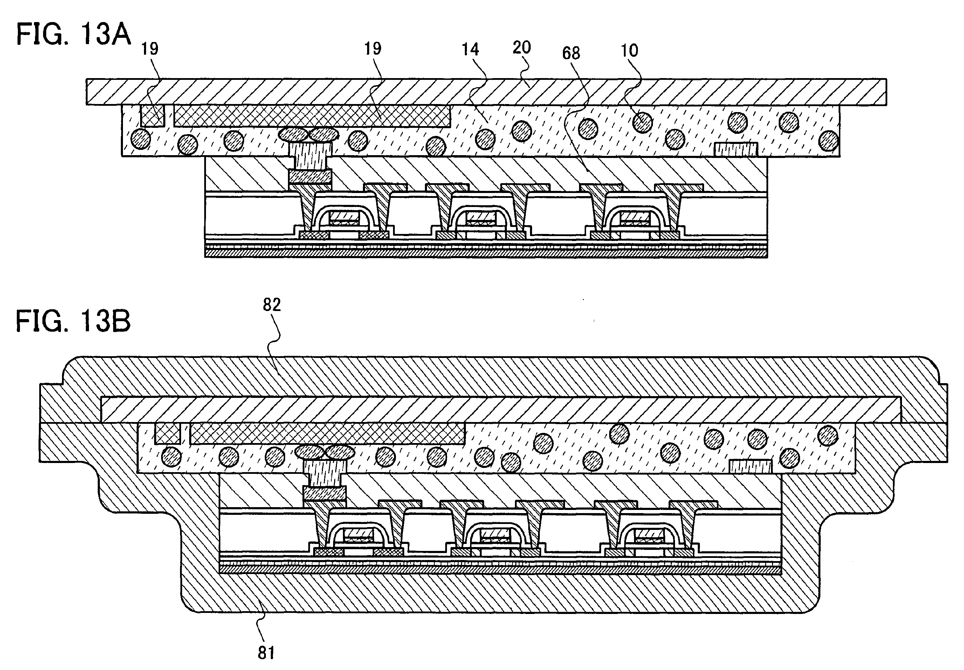

Next, the substrate 20 provided with the conductive layer 19 which functions as an antenna is prepared (see FIG 13A). The conductive layer 19 which functions as an antenna has a capacitor 86, and each of the conductive layer 19 which functions as an antenna and the capacitor 86 is formed by screen printing, droplet discharge, or the like (see FIGS. 14A and 14B). FIG 13A shows the conductive layer 19 which functions as an antenna. The resin layer 14 is a material where the conductive particle 10 is provided in an adhesive, which is also called an ACP (Anisotropic Conductive Paste). The resin layer 14 is uniformly formed by screen printing, droplet discharge, or the like.

Then, the substrates 89 and 20 are attached to each other by using the resin layer 14 (see FIGS. 13A and 14B). Then, if necessary, the insulating layer 68 and the resin layer 14 are attached to each other. At this time, one or both of pressure treatment and heat treatment is performed by using a flip-chip bonder, a die bonder, an ACF bonder, a pressure bonder, or the like.

Further, another substrate may also be provided on a surface of the stacked body including the plurality of transistors 54 (see FIG 13B). Specifically, another substrate may also be provided over one or both of respective surfaces of the substrates 89 and 20. In the structure shown in the drawing, a substrate 81 is provided on the surface of the substrate 89, and a substrate 82 is provided on the surface of the substrate 20. By providing the substrates 81 and 82, strength thereof can be further improved. The stacked body including the plurality of transistors 54 is sealed with the substrates 81 and 82 by melting the layer on each surface of the substrates 81 and 82, or an adhesive layer on each surface of the substrates 81 and 82 by heat treatment. In addition, pressure treatment is performed if necessary.

Note that, the thickness of the pseudo terminal can be larger than that of the terminal as shown in FIGS. 2A and 2B, and 6A and 6B, by further performing to the point where the pseudo terminal is formed in the step of manufacturing the pseudo terminal, the same step (e.g., screen printing or ink jetting).

In addition, the conductive layer which functions as an antenna, and the pseudo conductive layer as described in Embodiment Modes 3 to 6 may be formed into desired shape by screen printing, droplet discharge, or the like.

Further, the auxiliary terminal as described in Embodiment Modes 3 and 6 can be manufactured by employing the same method used in the step of forming the terminal, and thus can be manufactured without an additional step.

Although the stacked body including the plurality of transistors 54 is separated from the substrate 50 in this embodiment mode (see FIG. 11A), the invention is not limited to this mode; the substrate 50 may be thinned after forming the conductive layers 59 to 64 (see FIG 9A).

In order to thin the substrate 50, a surface over which the plurality of transistors 54 is not formed, of the substrate 50 is ground by using a grinding apparatus (e.g., a grinder). Preferably, the substrate 50 may be ground so as to have a thickness of 100 µm or less. Next, the surface over which the plurality of transistors 54 is not formed, of the ground substrate 50 is polished by using a polishing apparatus (e.g., a polishing pad or a polishing abrasive grain such as cerium oxide or the like). Preferably, the substrate 50 may be polished so as to have a thickness of 50 µm or less, more preferably 20 µm or less, and further more preferably 5 µm or less. Note that, in order to thin the substrate 50, one or both of grinding and polishing may be preferably performed. Moreover, before the grinding step and the polishing step, a layer for protection may be provided over the conductive layers 59 to 64 if necessary. Further, after the grinding step and the polishing step, one or both of a cleaning step for removing dust and a drying step may be preferably performed if necessary.

The thickness of the thinned substrate 50 may be appropriately determined in consideration of time required for the grinding step and the polishing step, time required for a cutting step which is performed later, use application of a semiconductor device, the strength required for the use application of the semiconductor device, and the like. For example, in the case where productivity is to be improved by shortening the time for the grinding step and the polishing step, the thickness of the substrate 50 after being polished is preferably set to be about 50 µm. In addition, in the case where productivity is to be improved by shortening the time required for the cutting step that is performed later, the thickness of the substrate 50 after being polished may be preferably set to be 20 µm or less, more preferably 5 µm or less. Moreover, in the case where a semiconductor device is to be attached to or embedded in a thin product, the thickness of the substrate 50 after being polished may be preferably set to be 20 µm or less, more preferably 5 µm or less. Further, the lower limit of the thickness of the thinned substrate 50 is not particularly limited; the substrate 50 may be thinned until the substrate 50 is removed (until the thickness of the substrate 50 becomes 0 µm).

Next, the conductive layer 66 is formed so as to be in contact with the conductive layer 59 (see FIG. 9B). Then, the conductive layer 66 is irradiated with a laser beam. Then, the insulating layer 68 is selectively formed (see FIG 9C). By laser beam irradiation, the opening 71 is formed (see FIG. 10A). Although the substrate 50 is not cut in forming the opening 71 in the structure shown in the drawing, the substrate 50 is preferably cut in the case where the substrate 50 is thinned. Thus, the step of separating the stacked body including the plurality of transistors 54 from the substrate 50 is preferably omitted. The subsequent steps are the same as those described above. In the case where the thinned substrate 50 is left without separating the stacked body including the plurality of transistors 54 from the substrate 50, penetration of harmful gas, moisture, or an impurity element can be suppressed. Thus, deterioration or destruction can be suppressed and reliability can be improved. Moreover, a barrier property can be improved.

### (Embodiment Mode 8)

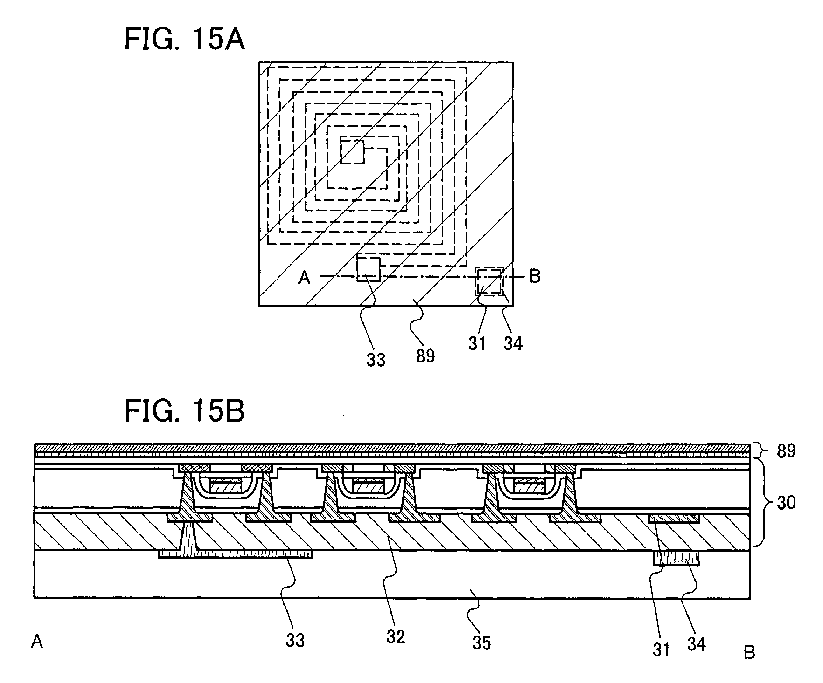

This embodiment mode describes a semiconductor device in which a conductive layer which functions as an antenna is formed over the same substrate, unlike the semiconductor devices described in Embodiment Modes 1 to 6, with reference to FIGS. 15A and 15B. FIG. 15B is a cross-sectional diagram along a line A-B of a top diagram of FIG 15A.

On one surface of the substrate 89, a layer 30 including an integrated circuit is formed (see FIG 15B). Over the layer 30 including the integrated circuit, a conductive layer 33 which is electrically connected thereto with an insulating layer 32 interposed therebetween and functions as an antenna is provided. Note that the layer 30 including the integrated circuit includes a plurality of transistors. The conductive layer 33 which functions as an antenna is covered with an insulating layer 35. Here, description is made of the case where the conductive layer 33 which functions as an antenna is a loop antenna.

In addition, as shown in FIGS. 15A and 15B, over the layer 30 including the integrated circuit, a terminal 31 (hereinafter, also referred to as a pseudo terminal) which is not electrically connected to (i.e., which is isolated from) the conductive layer 33 and the wiring included in the layer 30 including the integrated circuit is provided. Note that the number, shape, and position of the pseudo terminals of the invention are not limited to the structure shown in the drawing. That is, the position, shape, and number of the pseudo terminals can be freely changed as long as the pseudo terminal 31 is provided one or more in number.

In addition, as shown in FIGS. 15A and 15B, over the insulating layer 32 over the pseudo terminal 31, a conductive layer 34 (hereinafter, referred to as a pseudo conductive layer) which is not electrically connected to (i.e., which is isolated from) the conductive layer 33 and the wiring included in the layer 30 including the integrated circuit is provided. Note that the number, shape, and position of the pseudo conductive layers of the invention are not limited to the structure shown in the drawing. That is, the position, shape, and number of the pseudo conductive layers can be freely changed as long as the pseudo conductive layer 34 is provided one or more in number.

In a conventional structure in which the pseudo terminal and the pseudo conductive layer have not been provided, stress applied to a semiconductor device has been concentrated at a point where the conductive layer 33 and the wiring are connected to each other and as a result of this, this connecting point has been destroyed. However, by using the structure of the invention, the destruction of the connecting point between the conductive layer and the wiring can be suppressed. Consequently, strength can be improved as compared with the conventional semiconductor device, thereby the yield can be improved.

Note that although the description is made of the structure in which both of the pseudo terminal and the pseudo conductive layer are provided, only either one of them may be formed as well.

### (Embodiment Mode 9)

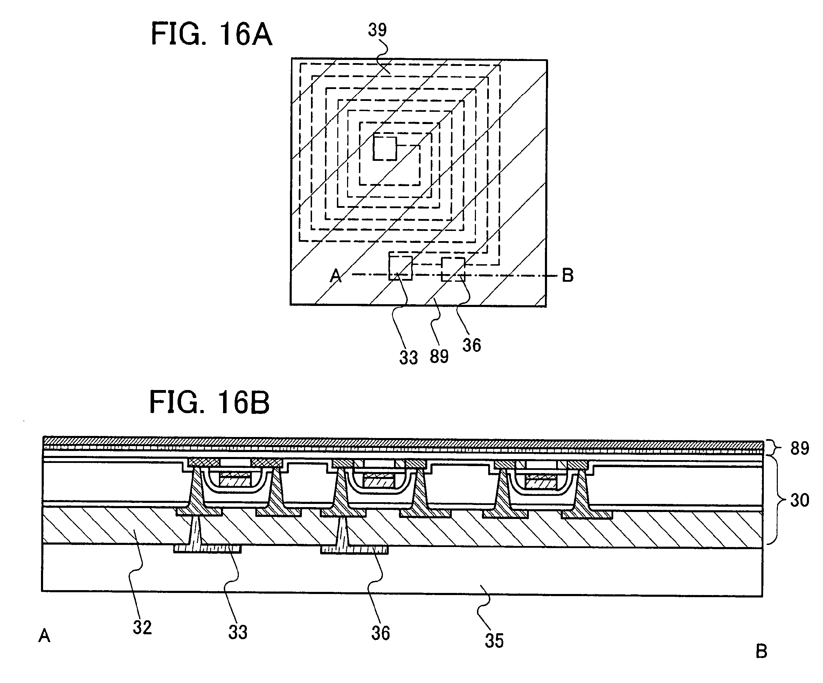

Embodiment Mode 9 is described with reference to FIGS. 16A and 16B. Description of the same portions as those in Embodiment Mode 8 is omitted.

FIGS. 16A is a top diagram of a semiconductor device, and FIG. 16B is a cross-sectional diagram along a line A-B of FIG. 16A. As shown in FIGS. 16A and 16B, over the layer 30 including the integrated circuit, the conductive layer 33 that is a part of the conductive layer which is electrically connected to the wiring included in the layer 30 including the integrated circuit and functions as an antenna, and an auxiliary conductive layer 36 that is a part of the conductive layer which is electrically connected to the wiring included in the layer 30 including the integrated circuit and functions as an antenna are provided (see FIG. 16B).

Note that a conductive layer 39 which functions as an antenna includes the conductive layer 33 that is the part of the conductive layer which functions as an antenna and the auxiliary conductive layer 36 that is the part of the conductive layer which functions as an antenna (see FIG. 16A).

Note that the number of the auxiliary conductive layers of the invention is not limited to the structure shown in the drawing. That is, the portion and number of the auxiliary conductive layers can be freely changed as long as the auxiliary conductive layer 36 is provided one or more in number.

By providing the auxiliary conductive layer 36, destruction of an electrical-joining portion between the conductive layer 33 and the wiring included in the layer 30 including the integrated circuit can be suppressed. Consequently, strength can be improved as compared with a conventional semiconductor device.

Further, the semiconductor device using the structure of the invention can operate even when the above-described joining portion is destroyed, unless an electrical-joining portion at which the auxiliary conductive layer 36 and the wiring included in the layer 30 including the integrated circuit are joined is destroyed. Consequently, the yield can be improved as compared with the conventional semiconductor device.

Note that the kind of the antenna is not limited to the shapes (kinds) described in Embodiment Modes 8 and 9. For example, a linear, a spiral, or a flat rectangular solid (e.g., a patch antenna) may be used. In addition, the antenna may have a multi-layer structure. It is to be understood that various changes into another shape will be apparent to those skilled in the art.

### (Embodiment Mode 10)

A manufacturing method of the semiconductor device of the invention is described with reference to cross-sectional diagrams of 17A to 17C, 18A and 18B, 19A and 19B, and 20. Here, description is made of a manufacturing method of the semiconductor device described in Embodiment Mode 8. Up to the step of forming the transistor and the insulating layer 57, the same as Embodiment Mode 7 can be applied; therefore, description thereof is omitted here.

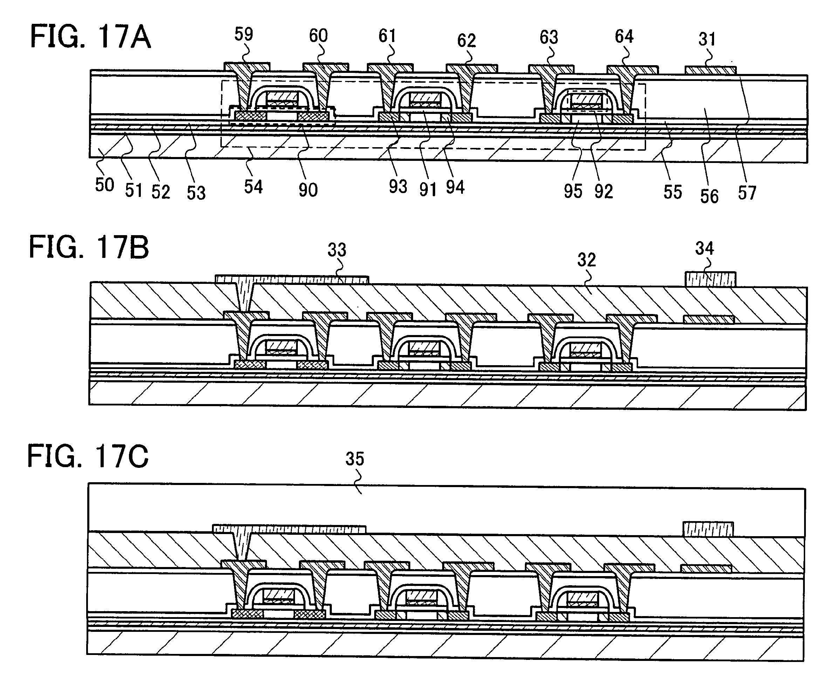

Then, openings are formed in the insulating layers 55 to 57, and the conductive layers 59 to 64 each connected to a source (also called a source region or a source electrode) or a drain (also called a drain region or a drain electrode) of each of the plurality of transistors 54, and the pseudo terminal 31 which is not electrically connected to (i.e., which is isolated from) the transistors are formed (i.e., which is electrically floating) (see FIG. 17A). The conductive layers 59 to 64 are provided in the same layer. In addition, the conductive layers 59 to 64 are source or drain wirings. Signals supplied from external are supplied to the plurality of transistors 54 through the conductive layers 59 to 64.

As the conductive layers 59 to 64 and the pseudo terminal 31, a single layer or a multi-layer is formed by sputtering or the like, of the following: an element of titanium, tungsten, chromium, aluminum, tantalum, nickel, zirconium, hafnium, vanadium, iridium, niobium, lead, platinum, molybdenum, cobalt, rhodium, and the like; an alloy material containing the element as its main component; or a compound material of an oxide or a nitride containing the element as its main component. As an example of the multi-layer structure of the conductive layers 59 to 64 and the pseudo terminal 31, there are a three-layer structure of titanium, aluminum, and titanium; a five-layer structure of titanium, titanium nitride, aluminum, titanium, and titanium nitride; a five-layer structure of titanium, titanium nitride, aluminum added with silicon, titanium, and titanium nitride; and the like.

Next, the insulating layer 32 is formed of a single layer or a multi-layer so as to cover the conductive layers 59 to 64 and the pseudo terminal 31 as shown in FIG 17B. Subsequently, a contact hole is formed in the insulating layer 32 covering the conductive layers 59 to 64 and the pseudo terminal 31, and the conductive layer 33 and the pseudo conductive layer 34 are formed. The conductive layer 33 functions as an antenna. The pseudo conductive layer 34 is not electrically connected to (i.e., which is isolated from) the conductive layer 33 and the conductive layers 59 to 64. Note that the conductive layer 33 and the pseudo conductive layer 34 are formed by screen printing, droplet discharge, or the like.

Then, laser beam irradiation is performed with a laser beam that can dissolve one or both of the conductive layers 59 and 33. Although the conductive layers 59 and 33 are partially in contact with each other before performing the laser beam irradiation, the portion where the conductive layers 59 and 33 are in contact with each other can be increased by the laser beam irradiation. Thus, more secured electrical connection between the conductive layers 59 and 33 can be obtained; thus reliability can be improved. As the laser, there are a gas laser, a liquid laser, and a solid state laser when classified by a medium; and a free electron laser, a semiconductor laser, and an X-ray laser when classified by a characteristic of oscillation; however, any of the lasers may be used in the invention. Preferably, a gas laser or a solid state laser may be used, and more preferably, a solid state laser may be used. Furthermore, either of a continuous oscillation laser or a pulsed oscillation laser may be used in the invention.

After that, over the insulating layer 32, the conductive layer 33 which functions as an antenna, and the pseudo conductive layer 34, a protective layer, e.g., a layer containing carbon such as Diamond-Like Carbon (DLC), a layer containing silicon nitride, or a layer containing silicon nitride oxide may be formed.

Next, as shown in FIG. 17C, the insulating layer 35 is formed over the insulating layer 32, the conductive layer 33 which functions as an antenna, and the pseudo conductive layer 34 by screen printing or the like. The insulating layer 35 which is provided as a protective layer in a later peeling step may be preferably a planarizing layer.

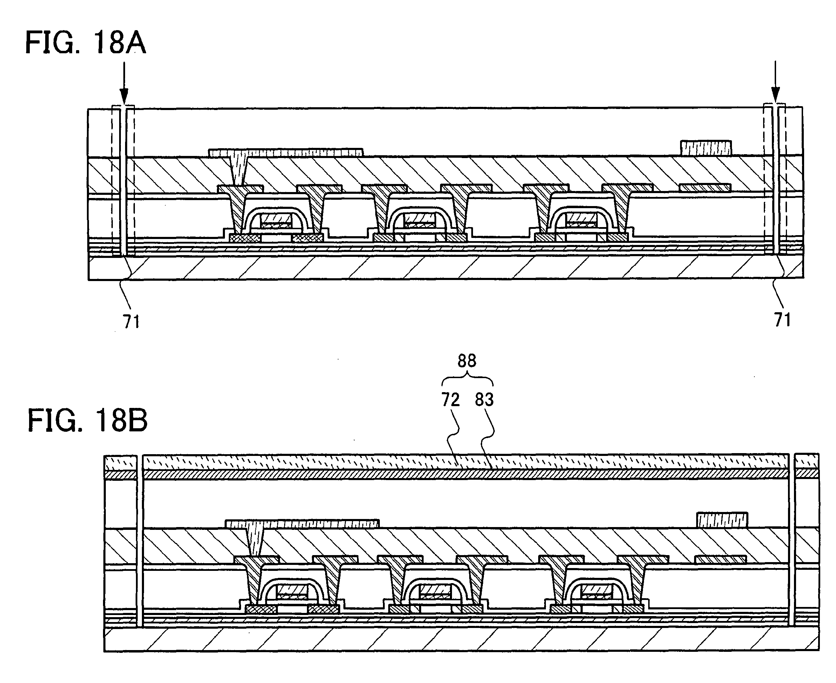

Then, the opening 71 so as to expose at least part of the release layer 52 is formed (see FIG 18A). In terms of short processing time, this step may preferably be carried out by laser beam irradiation: the laser beam irradiation is performed to the substrate 50, the insulating layer 51, the release layer 52, and the insulating layers 53, 55 to 57, 32 and 35; and the surface of the insulating layer 35 is irradiated first with a laser beam. The opening 71 is formed so as to expose at least part of the release layer 52; therefore, the opening 71 is provided at least in the insulating layers 53, 55 to 57, 32 and 35. The structure shown in the drawing is the case where a laser beam reaches up to the insulating layer 51, and the insulating layers 51, 53, 55 to 57, 32 and 35 are separated. Note that the laser beam may reach up to the substrate 50.

In addition, as a laser, a solid state laser with a wavelength of 150 to 380 nm that is an ultraviolet region may be preferably used. More preferably, an Nd: YVO₄ laser with a wavelength of 150 to 380 nm may be used. This is because, as for the Nd: YVO₄ laser with a wavelength of 150 to 380 nm, light is easily absorbed in the substrate compared with other lasers on longer wavelength side, and ablation processing is possible. Moreover, the periphery of a processed portion is not affected and processability is good.

Next, the substrate 88 is provided over the insulating layer 68 (see FIG. 18B). The substrate 88 is a substrate in which the insulating layer 72 and the adhesive layer 83 are stacked, which is a substrate of a heat-peeling type. The adhesive layer 83 is a layer the adhesivity of which decreases by heat treatment, which is, for example, a layer formed of a material utilizing softening of a thermoplastic adhesive at the time of heating, a layer formed of a material where a microcapsule that expands by heating or a foaming agent is mixed, a layer formed of a material in which thermal meltability or a pyrolytic property is given to a thermosetting resin, or a layer using deterioration of interface intensity because of penetration of moisture or expansion of a water-absorbing resin because of the deterioration.

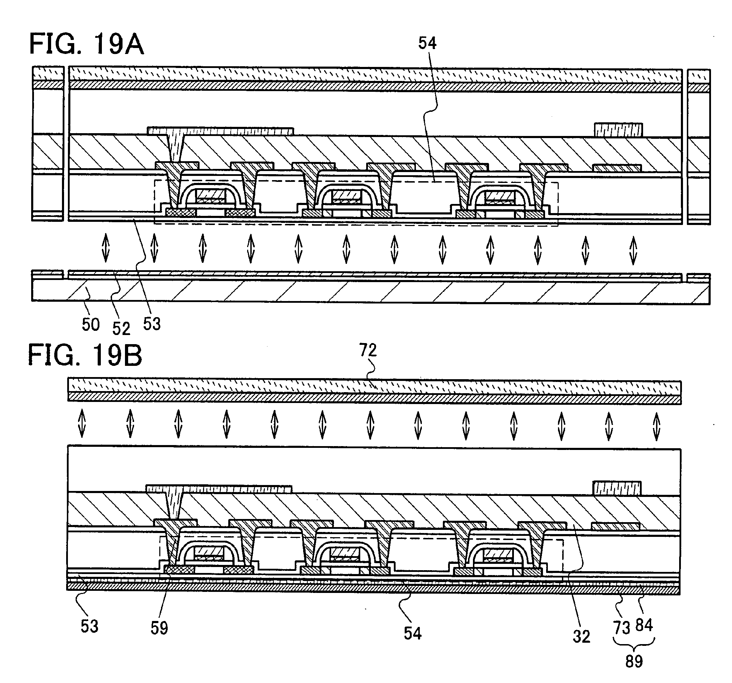

Then, using the substrate 88, the stacked body including the plurality of transistors 54 is separated from the substrate 50 (see FIG. 19A). The separation of the stacked body including the plurality of transistors 54 is performed either inside the release layer 52 or at the interface between the release layer 52 and the insulating layer 53 as a boundary. The structure shown in the drawing is the case where the separation is performed at the interface between the release layer 52 and the insulating layer 53 as a boundary. In this manner, the separation step can be performed easily in short time by using the substrate 88.

Next, as well as a substrate 89 is provided on the surface of the insulating layer 53, the stacked body including the plurality of transistors 54 is separated from the substrate 88 by heat treatment (see FIG 19B). The substrate 89 is a substrate in which the insulating layer 73 and the adhesive layer 84 are stacked. The adhesive layer 84 is a layer the adhesivity of which increases by heat treatment, which corresponds to a layer containing a thermoplastic resin. The thermoplastic resin corresponds to polyethylene, polystyrene, polypropylene, polyvinyl chloride, or the like.

As described above, since the substrate 88 is the substrate of a heat-peeling type, the adhesivity between the substrate 88 and the insulating layer 35 decreases by heat treatment; thus, the stacked body including the plurality of transistors 54 is separated from the substrate 88. At the same time, the thermosetting resin on the surface of the substrate 89 is cured by the heat treatment; thus, the adhesivity between the insulating layer 53 and the one surface of the substrate 89 increases. In this manner, the step of separating the stacked body from the substrate 88 and the step of providing the stacked body over the substrate 89 can be carried out at the same time by using the two substrates 88 and 89 provided with the adhesive layers having different properties. Consequently, manufacturing time can be shortened.

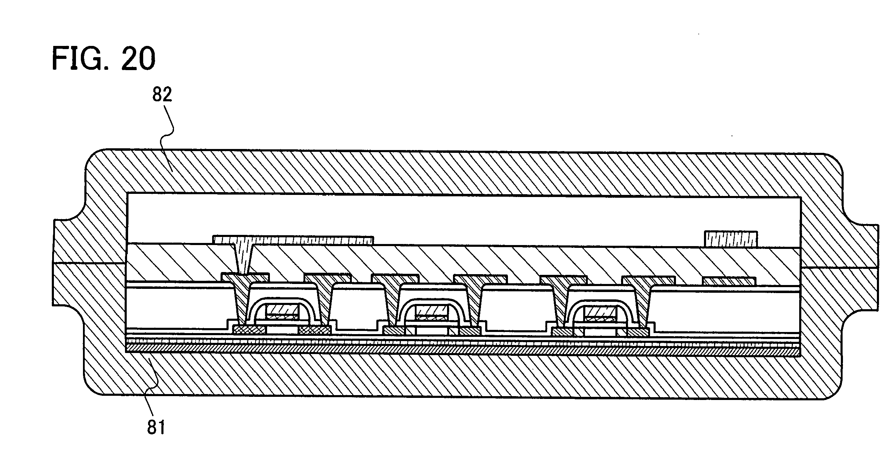

Further, a substrate may also be provided on a surface of the stacked body including the plurality of transistors 54 (see FIG. 20). Specifically, a substrate may be further provided over one or both of respective surfaces of the insulating layer 35 and the substrate 89. In the structure shown in the drawing, the substrate 81 is provided on the surface of the substrate 89, and the substrate 82 is provided on the surface of the insulating layer 35. By providing the substrates 81 and 82, strength thereof can be further improved. The stacked body including the plurality of transistors 54 is sealed with the substrates 81 and 82 by melting the layer on each surface of the substrates 81 and 82, or the adhesive layer on each surface of the substrates 81 and 82 by heat treatment. In addition, pressure treatment is performed if necessary.

Note that in order to form the structure described in Embodiment Mode 9, a point at which the conductive layer which functions as an antenna is electrically connected to the wiring and the number of the points may be increased, without forming the pseudo conductive layer and the pseudo terminal.

Although the stacked body including the plurality of transistors 54 is separated from the substrate 50 in this embodiment mode, the invention is not limited to this mode; the substrate 50 may be thinned. The same step as that in Embodiment Mode 7 is applied to a step thereof, thus description thereof is omitted here.

### (Embodiment Mode 11)

In order to suppress adverse effect by electrostatic, it is preferable to use an antistatic substrate capable of suppressing generation of an electric charge for the semiconductor device of the present invention. Thus, the antistatic substrate is described with reference to FIGS. 21A to 21E. Description below is made of the antistatic substrate by broadly classifying into five types.

The first type is a substrate where a layer 252 containing a conductive material is provided over an insulating layer 251 (see FIG. 21A). As the layer 252 containing a conductive material, a layer containing a metal such as aluminum, gold, zinc, or indium tin oxide is formed by using plating, vapor deposition, sputtering, or the like. Alternatively, as the layer 252 containing a conductive material, a layer containing a conductive coating material is formed. A conductive coating material is a material where fine particles of a conductive material (e.g., particles of carbon black or silver) are mixed in a coating material.

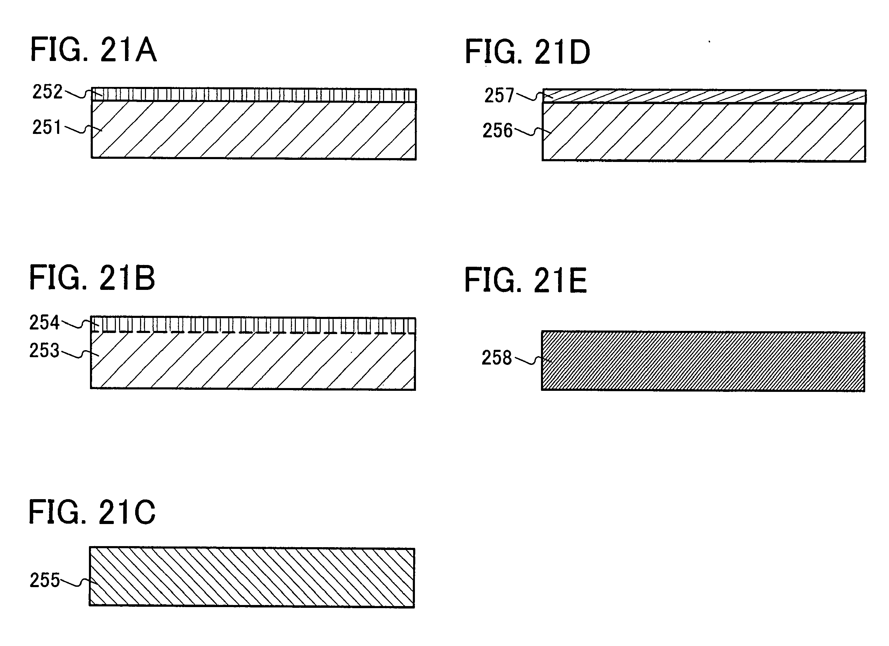

The second type is a substrate where a hydrophilic layer 254 is provided on a surface of an insulating layer 253 (see FIG 21B). In order to achieve hydrophilicity, treatment by acid or surface treatment by plasma is used. The third type is a substrate including an insulating layer 255 mixed with a conductive material (see FIG 21 C). As the conductive material, a metal powder, carbon black, a carbon fiber, or the like is used.

By making the antistatic substrate conductive as the above-described three substrates, and grounding one end of the substrate, an electric charge can be easily removed. Consequently, adverse effect by static electricity can be suppressed.

The fourth type is a substrate where a layer 257 containing an antistatic agent is provided over an insulating layer 256 (see FIG 21 D). The fifth type is a substrate including an insulating layer 258 mixed with an antistatic agent (see FIG 21E). The antistatic agent is classified into an anionic antistatic agent, a cationic antistatic agent, an amphoteric antistatic agent, and a non-ionic antistatic agent. As an anionic antistatic agent, there are alkylsulfonate salt and the like; as a cationic antistatic agent, there are tetraalkylammonium salt and the like; as an amphoteric antistatic agent, there are alkylbetaine and the like; and as a non-ionic antistatic agent, there are glycerin fatty acid ester and the like.

By using an antistatic agent as the above-described two substrates, leakage of an electric charge can be promoted. Consequently, adverse effect by static electricity can be suppressed.

The insulating layers 251, 253, and 256 are formed by using the following: silicone, polyethylene, polypropylene, polystyrene, an AS resin, an ABS resin (a resin where acrylonitrile, butadiene, and styrene are polymerized), an acrylic resin, polyvinyl chloride, polyacetal, polyamide, polycarbonate, modified polyphenylene ether, polybutylene terephthalate, polyethylene naphthalate, polyethylene terephthalate, poly sulfone, polyethersulfone, polyphenylene sulfide, polyamide imide, polymethylpentene, a phenol resin, a urea resin, a melamine resin, an epoxy resin, a diallyl phthalate resin, an unsaturated polyester resin, polyimide, polyurethane, or the like.

In addition, each of the above-described substrates (also called a base, a film, or a tape) preferably has flexibility. In addition, an adhesive layer may be provided on a surface of the substrate. The adhesive layer is a layer including an adhesive. Moreover, the surface of the substrate may be coated with silicon dioxide (silica). By the coating, a waterproof property of the substrate can be maintained even in an atmosphere with a high temperature and a high humidity. Further, the surface may be coated with a material containing carbon as its main component (e.g., diamond-like carbon). By coating, strength is enhanced, and deterioration and destruction of the stacked body including the plurality of transistors 54 can be suppressed.

### (Embodiment Mode 12)

The semiconductor device of the invention includes a plurality of transistors. Each of the plurality of transistors includes a semiconductor layer, a gate insulating layer, and a gate electrode. This embodiment mode describes an example of a manufacturing method of the semiconductor layer included in each of the plurality of transistors.

First, an amorphous semiconductor layer is formed by sputtering, LPCVD, plasma CVD, or the like. Next, the amorphous semiconductor layer is crystallized by a laser crystallization method, an RTA (Rapid Thermal Anneal) method, a thermal crystallization method using an annealing furnace, a thermal crystallization method using a metal element which promotes crystallization, a method in which a thermal crystallization method using a metal element which promotes crystallization and a laser crystallization method are combined, or the like to form a crystallized semiconductor layer. Then, the crystallized semiconductor layer is processed into a desired shape.

Among the above manufacturing methods, a crystallization method with heat treatment and a crystallization method in which irradiation of a continuous wave laser beam or a laser beam oscillating with a frequency of 10 MHz or more is performed may be preferably used in combination. By irradiating the semiconductor layer with a continuous wave laser beam or a laser beam oscillating with a frequency of 10 MHz or more, the surface of the crystallized semiconductor layer can be planarized. By planarizing the surface of the crystallized semiconductor layer, a gate insulating layer which is a layer above the semiconductor layer can be thinned, and besides, pressure resistance of the gate insulating layer can be improved.

Moreover, among the above manufacturing methods, a continuous wave laser beam or a laser beam oscillating with a frequency of 10 MHz or more may be preferably used. A semiconductor layer which is crystallized by being scanned in one direction while being irradiated with a continuous wave laser beam or a laser beam oscillating with a frequency of 10 MHz or more, has a characteristic that crystals are grown in a scanning direction of the beam. A transistor in which characteristic variation is reduced and field effect mobility is high can be obtained by arranging the transistor such that the scanning direction is aligned with a channel length direction (a direction in which carriers are flown when a channel formation region is formed) and by employing the following manufacturing method to form the gate insulating layer.

Next, an example of a manufacturing method of a gate insulating layer included in each of the plurality of transistors is described. The gate insulating layer may be formed by performing plasma treatment to the semiconductor layer so as to oxidize or nitride the surface of the semiconductor layer. For example, plasma treatment is employed, in which a rare gas (e.g., He, Ar, Kr, or Xe) and a mixed gas (e.g., oxygen, oxidized nitrogen, ammonia, nitrogen, or hydrogen) are introduced. In this case, when excitation of plasma is performed by introducing a microwave, plasma with a low electron temperature and high density (hereinafter abbreviated as high-density plasma) can be generated. The surface of the semiconductor layer is oxidized or nitrided by oxygen radicals (OH radicals may be included) or nitrogen radicals (NH radicals may be included) generated by this high-density plasma; accordingly, an insulating layer having a thickness of 5 to 10 nm is formed on the semiconductor layer. This insulating layer having a thickness of 5 to 10 nm may be preferably used as the gate insulating layer.

Note that a reaction of this case by treatment using high-density plasma which is a solid-phase reaction can extremely reduce the interface-state density between the gate insulating layer and the semiconductor layer. Such high-density plasma treatment directly oxidizes (or nitrides) the semiconductor layer (crystalline silicon or polycrystalline silicon), so that variation in thickness of a gate insulating layer to be formed can be extremely small. In addition, the semiconductor layer in a crystal grain boundary of crystalline silicon is not oxidized too much, thus an extremely desirable state can be obtained. That is, by performing solid-phase oxidation of the semiconductor layer surface in the high-density plasma treatment described here, a gate insulating layer which has favorable uniformity and low interface-state density can be formed without excessive oxidation in a crystal grain boundary.

Note that as the gate insulating layer included in the transistor, only the insulating layer formed by high-density plasma treatment may be used; alternatively, an insulating layer of silicon oxide, silicon oxynitride, silicon nitride, or the like may be stacked by CVD using plasma or a thermal reaction, over the insulating layer formed by high-density plasma treatment. In any case, characteristic variation can be reduced in the transistor including the insulating layer formed by high-density plasma as the gate insulating layer or part of the gate insulating layer.

In addition, the semiconductor layer, the gate insulating layer, and other insulating layer included in the transistor are formed by plasma treatment in some cases. Such plasma treatment is preferably performed with an electron density of 1 × 10¹¹ cm⁻³ or more and an electron temperature of plasma of 1.5 eV or less. Specifically, the plasma treatment is preferably performed with an electron density of 1 × 10¹¹ cm⁻³ to 1 × 10¹³ cm⁻³ and an electron temperature of plasma of 0.5 eV to 1.5 eV.

When plasma has high electron density, and a low electron temperature in the vicinity of an object to be processed (e.g., a semiconductor layer, a gate insulating layer, or the like included in a transistor), the object to be processed can be prevented from being damaged by plasma. In addition, since the electron density of plasma is as high as 1 × 10¹¹ cm⁻³ or more, oxide or nitride which is formed by oxidizing or nitriding the object to be processed using plasma treatment, can form a film that is superior to a thin film formed by CVD, sputtering, or the like, in uniformity of the thickness or the like, and is dense. Moreover, since the electron temperature of the plasma is as low as 1.5 eV or less, oxidizing treatment or nitriding treatment can be performed at a lower temperature compared with conventional plasma treatment or thermal oxidation. For example, even when plasma treatment is performed at a temperature lower than the strain point of a glass substrate by 100°C or more, oxide or nitride can be formed by sufficiently oxidizing or nitriding a surface of the object to be processed.

The structure of this embodiment mode can be combined with any structure of the other embodiment modes.

### (Embodiment Mode 13)

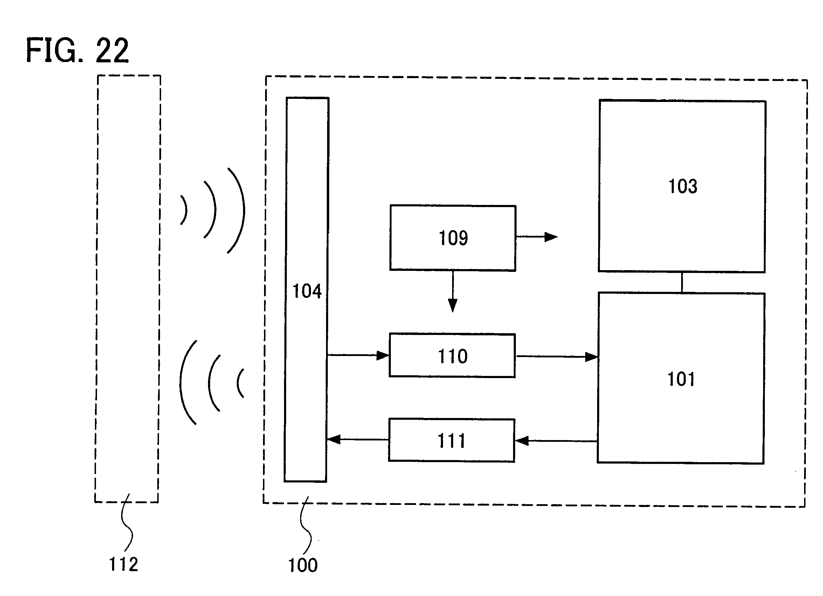

A structure of the semiconductor device of the invention is described with reference to FIG. 22. A semiconductor device 100 of the invention includes an arithmetic processing circuit 101, a memory circuit 103, an antenna 104, a power supply circuit 109, a demodulation circuit 110, and a modulation circuit 111. The semiconductor device 100 includes the antenna 104 and the power supply circuit 109 as mandatory components, and the other components are arbitrarily provided according to use application of the semiconductor device 100.

The arithmetic processing circuit 101 analyzes commands, controls the memory circuit 103, outputs data which is transmitted to the outside, to the modulation circuit 111, or the like, based on a signal inputted from the demodulation circuit 110.

The memory circuit 103 includes a circuit including a memory element and a control circuit for controlling writing and reading of data. The memory circuit 103 has stored at least an identification number of the semiconductor device. The identification number is used for distinguishing the semiconductor device from other semiconductor devices. In addition, the memory circuit 103 includes one or plural kinds of memories of an organic memory, a DRAM (Dynamic Random Access Memory), an SRAM (Static Random Access Memory), an FeRAM (Ferroelectric Random Access Memory), a mask ROM (Read Only Memory), a PROM (Programmable Read Only Memory), an EPROM (Electrically Programmable Read Only Memory), an EEPROM (Electrically Erasable Programmable Read Only Memory), and a flash memory. The organic memory has a structure in which a layer containing an organic compound is interposed between a pair of conductive layers. Since the organic memory has such a simple structure, a manufacturing process can be simplified and cost can be reduced. In addition, because of the simple structure, the area of a stacked body can be easily reduced and high capacity can be easily achieved. Thus, it is preferable to use an organic memory for the memory circuit 103.

The antenna 104 converts a carrier wave supplied from a reader/writer 112 into an alternating electrical signal. In addition, load modulation is applied by the modulation circuit 111. The power supply circuit 109 generates power supply voltage by using the alternating electrical signal converted by the antenna 104 and supplies the power supply voltage to each circuit.

The demodulation circuit 110 demodulates the alternating electrical signal converted by the antenna 104 and supplies the demodulated signal to the arithmetic processing circuit 101. The modulation circuit 111 applies load modulation to the antenna 104, based on a signal supplied from the arithmetic processing circuit 101.

The reader/writer 112 receives the load modulation applied to the antenna 104 as a carrier wave. In addition, the reader/writer 112 transmits the carrier wave to the semiconductor device 100. Note that the carrier wave refers to an electromagnetic wave generated by the reader/writer 112.

The structure of this embodiment mode can be combined with any structure of the other embodiment modes.

### (Embodiment Mode 14)

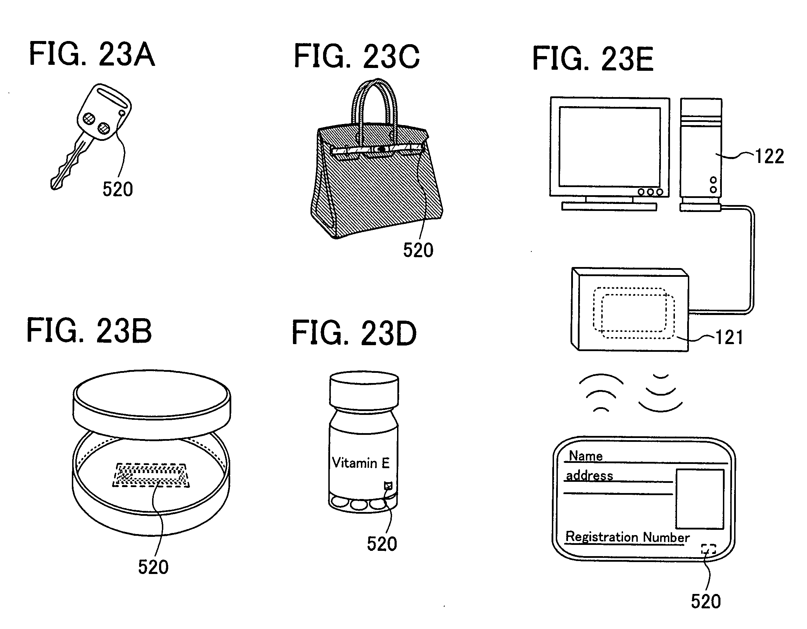

The semiconductor device of the invention can be used in various objects and various systems by utilizing a function capable of transmitting and receiving data without contact. The various objects include, for example, keys (see FIG. 23A), banknotes, coins, securities, bearer bonds, certificates (a driver's license, a resident's card, or the like), books, packing containers (a petri dish or the like; see FIG. 23B), personal accessories and ornaments (a bag, glasses, or the like; see FIG. 23C), packing and wrapping containers (wrapping paper, a bottle, or the like; see FIG. 23D), recording media (a disk, a video tape, or the like), vehicles (a bicycle or the like), foods, clothing, everyday articles, and electronic devices (a liquid crystal display device, an EL display device, a television device, a portable terminal, or the like). The semiconductor device of the invention is fixed by being attached to the surfaces of the objects having various forms as described above, or being embedded into the objects.

In addition, the various systems include a physical distribution-inventory management system, a certification system, a distribution system, a production record system, a book management system, and the like. By utilizing a semiconductor device 520 of the invention, high-function, multifunction, and a high-added value of the system can be achieved. For example, the semiconductor device 520 of the invention is provided inside an identification card, and a reader/writer 121 is provided at an entrance of a building or the like (see FIG 23E). The reader/writer 121 reads an identification number inside the identification card that every person possesses and supplies information related to the identification number that has been read to a computer 122. The computer 122 determines whether to permit the person's entrance or exit, based on the information supplied from the reader/writer 121. In such a manner, by utilizing the semiconductor device of the invention, an entrance-exit management system with improved convenience can be provided.

The structure of this embodiment mode can be combined with any structure of the other embodiment modes.
This application is based on Japanese Patent Application serial no. 2005-285018 filed in Japan Patent Office on 29th, September, 2005, the entire contents of which are hereby incorporated by reference.

## Claims

1. A semiconductor device comprising:
a transistor formed over a substrate;
a first insulating layer provided over the transistor;
a first conductive layer connected to a source or a drain of the transistor via an opening of the first insulating layer;
a second conductive layer provided over the first insulating layer;
a second insulating layer provided over the first and the second conductive layers;
an antenna connected to the first conductive layer via an opening of the second insulating layer; and
a third conductive layer provided over the second conductive layer while interposing the second insulating layer,
wherein the second and third conductive layers are electrically floating.

2. A semiconductor device comprising:
an integrated circuit formed over a first substrate;
an insulating layer formed over the integrated circuit;
a first conductive layer formed over the insulating layer and electrically connected to the integrated circuit;
a second conductive layer formed over the insulating layer; and
an antenna formed over a second substrate,
wherein the first substrate and the second substrate are opposed to each other while interposing at least the first and the second conductive layers and the antenna therebetween,
wherein the first conductive layer is electrically connected to the antenna, and
wherein the second conductive layer is electrically floating.

3. A semiconductor device comprising:
an insulating layer formed over an integrated circuit;
a first terminal and a second terminal formed on a surface of the insulating layer; and
a conductive layer which is formed over the first terminal and functions as an antenna electrically connected to the first terminal,
wherein the second terminal is electrically isolated from the conductive layer.

4. A semiconductor device comprising:
an insulating layer formed over an integrated circuit;
two first terminals formed on a surface of the insulating layer;
a conductive layer which is formed over the first terminal and functions as an antenna electrically connected to the first terminals; and
one or more second terminals formed of a same material on the same surface as the first terminals and are electrically connected to the conductive layer.

5. A semiconductor device comprising:
a transistor formed over a substrate;
a first insulating layer provided over the transistor;
a first conductive layer connected to a source or a drain of the transistor via an opening provided in the first insulating layer;
a second conductive layer provided over the first insulating layer;
a second insulating layer provided over the first insulating layer, the first conductive layer, and the second conductive layer;
a third conductive layer which is provided so as to fill an opening provided in the second insulating layer and is in contact with the second conductive layer;
a layer of a conductive material provided over the second insulating layer; and
a fourth conductive layer which is electrically connected to the third conductive layer,
wherein the layer of the conductive material is electrically isolated from the first conductive layer, the second conductive layer, the third conductive layer, and the fourth conductive layer.

6. A semiconductor device comprising:
a transistor formed over a substrate;
a first insulating layer provided over the transistor;
a first conductive layer connected to a source or a drain of the transistor via an opening provided in the first insulating layer;
a second conductive layer provided over the first insulating layer;
a second insulating layer provided over the first insulating layer, the first conductive layer, and the second conductive layer;
a third conductive layer which is provided so as to fill an opening provided in the second insulating layer and is in contact with the second conductive layer;
a fourth conductive layer electrically connected to the third conductive layer; and
a layer of a conductive material formed of a same material on a same surface as the fourth conductive layer,
wherein the layer of the conductive material is electrically isolated from the first conductive layer, the second conductive layer, the third conductive layer, and the fourth conductive layer.

7. A semiconductor device comprising:
a transistor formed over a substrate;
a first insulating layer provided over the transistor;
a first conductive layer connected to a source or a drain of the transistor via an opening provided in the first insulating layer;
a second conductive layer provided over the first insulating layer;
a second insulating layer provided over the first insulating layer, the first conductive layer, and the second conductive layer;
a third conductive layer which is provided so as to fill an opening provided in the second insulating layer and is in contact with the second conductive layer;
a layer of a first conductive material provided over the second insulating layer;
a fourth conductive layer electrically connected to the third conductive layer; and
a layer of a second conductive material formed of a same material on a same surface as the fourth conductive layer,
wherein the layer of the first conductive material and the layer of the second conductive material are electrically isolated from the first conductive layer, the second conductive layer, the third conductive layer, and the fourth conductive layer.

8. The semiconductor device according to claim 3, the semiconductor device further comprising a substrate provided over the conductive layer, wherein a distance between the first terminal and the conductive layer and a distance between the second terminal and the substrate are almost equal.

9. The semiconductor device according to claim 3, the semiconductor device further comprising a layer of a conductive material formed of a same material on the same surface as the conductive layer, and electrically isolated from the conductive layer.

10. The semiconductor device according to claim 5, the semiconductor device further comprising a substrate provided over the fourth conductive layer, wherein a distance between the third conductive layer and the fourth conductive layer and a distance between the layer of the conductive material and the substrate are almost equal.

11. The semiconductor device according to claim 2, wherein the integrated circuit includes a transistor.

12. The semiconductor device according to claim 3, wherein the integrated circuit includes a transistor.

13. The semiconductor device according to claim 4, wherein the integrated circuit includes a transistor.

14. The semiconductor device according to claim 1, wherein the antenna is a dipole antenna.

15. The semiconductor device according to claim 2, wherein the antenna is a dipole antenna.

16. The semiconductor device according to claim 3, wherein the conductive layer is a dipole antenna.

17. The semiconductor device according to claim 4, wherein the conductive layer is a dipole antenna.

18. The semiconductor device according to claim 5, wherein the fourth conductive layer is a dipole antenna.

19. The semiconductor device according to claim 6, wherein the fourth conductive layer is a dipole antenna.

20. The semiconductor device according to claim 7, wherein the fourth conductive layer is a dipole antenna.

21. The semiconductor device according to claim 1, wherein the antenna is a loop antenna.

22. The semiconductor device according to claim 2, wherein the antenna is a loop antenna.

23. The semiconductor device according to claim 3, wherein the conductive layer is a loop antenna.

24. The semiconductor device according to claim 4, wherein the conductive layer is a loop antenna.

25. The semiconductor device according to claim 5, wherein the fourth conductive layer is a loop antenna.

26. The semiconductor device according to claim 6, wherein the fourth conductive layer is a loop antenna.

27. The semiconductor device according to claim 7, wherein the fourth conductive layer is a loop antenna.
